(19) Europäisches Patentamt / European Patent Office / Office européen des brevets

(11) **EP 4 590 099 A1**

(12) **EUROPEAN PATENT APPLICATION**


(43) Date of publication:
**23.07.2025 Bulletin 2025/30**

(21) Application number: **25152344.5**

(22) Date of filing: **16.01.2025**

(51) International Patent Classification (IPC):
***H10K 30/50*** *(2023.01)* ***H10K 30/85*** *(2023.01)*

(52) Cooperative Patent Classification (CPC):
**H10K 30/50; H10K 30/85;** H10K 85/50

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **18.01.2024 US 202418416458**



(71) Applicants:
- **Kaunas University of Technology**
  **44249 Kaunas (LT)**
- **King Abdullah University Of Science And Technology**
  **Thuwal 23955-6900 (SA)**

(72) Inventors:
- **Getautis, Vytautas**
  **Kaunas (LT)**
- **Svirskaite, Lauryna Monika**
  **Kaunas (LT)**
- **Malinauskas, Tadas**
  **Kaunas (LT)**
- **Magomedov, Artiom**
  **Kaunas (LT)**
- **De Wolf, Stefaan**
  **Thuwal (SA)**
- **Azmi, Randi**
  **Thuwal (SA)**

(74) Representative: **AAA Law**
**A. Gostauto 40B**
**03163 Vilnius (LT)**


(54) **ELECTRON TRANSPORTING SELF-ASSEMBLING MONOLAYER COMPOUND FOR USE IN OPTOELECTRONIC AND/OR PHOTOELECTROCHEMICAL DEVICES AND MANUFACTURE THEREOF**


(57) The present disclosure provides new electron transporting naphthalene-diimide-based and naphthalene-imide-based compounds containing phosphonic or phosphoric acid as an anchoring group, and their use as electron transport materials in optoelectronic and/or photoelectrochemical devices, in particular photovoltaic devices and a method of fabrication thereof. The structure of the compounds of the present invention allows covalent binding to the transparent conducting oxide surface with suitable energetic levels, minimized thickness at low temperatures.


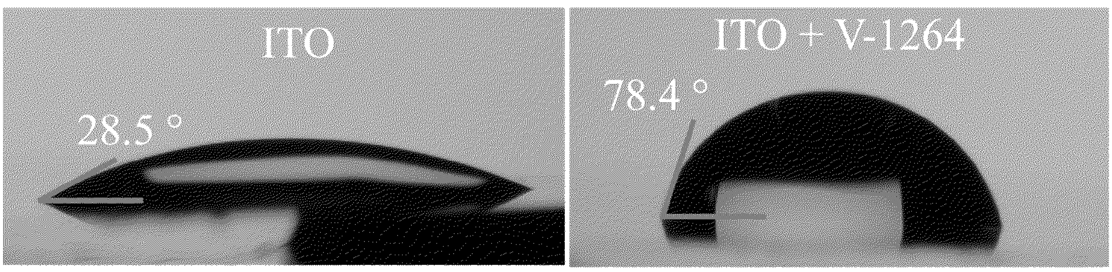


**FIG. 5**

EP 4 590 099 A1

## Description

TECHNICAL FIELD

The invention generally relates to new self-assembling monolayer compounds, and their use as electron transport materials in optoelectronic and/or photoelectrochemical devices, in particular photovoltaic devices and a method of fabrication thereof.

BACKGROUND OF THE INVENTION

Over the past decades, there has been a strong interest in renewable energy sources, especially the most potent among them - the sun. The conversion of solar energy to electrical current using thin film third-generation photovoltaics (PV) has been widely explored for the last two decades. The sandwich/monolithic-type PV devices, consisting of a mesoporous photoanode with an organic/inorganic light harvester, redox electrolyte/solid-state hole conductor, and counter electrode, have gained significant interest due to the facile fabrication, the flexibility in the selection of materials and the low cost of production.

Organic-inorganic metal halide perovskite solar cells (PSCs) have experienced rapid development in recent years, with its power conversion efficiency (PCE) improving from 3.8% in 2009 to an impressive 26.1% in 2023;[1] such values are now comparable with those of market-established solar cell technologies such as crystalline silicon (c-Si) and copper indium gallium diselenide (CIGS). Moreover, PSCs can be manufactured using low-cost, scalable, simple solution-processing techniques, further underlining the promise of PSCs as a future mainstream technology.[2] Moreover, PSCs can also be integrated as top cell into tandems when combining either with c-Si, CIGS, organic or another PSC as bottom cell technology, yielding PCEs well above those of the sub-cells, opening pathways toward affordable ultrahigh efficient PV.[3] Despite the fact that perovskite solar cells have demonstrated impressive efficiency there are still considerable obstacles to overcome before the technology can be commercialized. The most important of these is the insufficient stability of the devices, mainly due to decomposition of the perovskite absorber when it is exposed to the ambient environment.

A common PSC device consists of two electrodes, the perovskite light absorber, an n-type electron transport layer (ETL), and a p-type hole transport layer (HTL).[4] The perovskite layer is sandwiched between ETL and HTL for efficient charge transport. The outer electrodes, including transparent conducting glass covered with transparent conducting oxide (TCO) such as indium tin oxide (ITO) or fluorine-doped tin oxide (FTO) and counter electrode (Au, Ag or carbon), are used for charge collection. Three types of device configurations are commonly used to fabricate PSCs, including the mesoporous n-i-p, planar n-i-p, and planar p-i-n structure, in which n represents ETL, p represents HTL, and i represents the perovskite layer, respectively (FIG. 1). The n-i-p structure has systematically outperformed its p-i-n counterpart, up to present.[5]

To design stable and efficient PSCs, the selection of the electron and hole transport layers, as well as the perovskite material is crucial. The ETL consisting of metal oxides ($TiO_2$, ZnO, $SnO_2$) promotes the collection of photogenerated electrons from the perovskite layer to the corresponding electrode for regular PSCs and hydrophobic [6,6]-phenyl-C61-butyric acid methyl ester (PCBM) or its derivatives for inverted PSCs.[6] On the other hand, the 2,2',7,7'-tetrakis[*N*,*N*-di(4-methoxyphenyl)amino]-9,9'-spirobifluorene (Spiro-MeOTAD) has been the most employed hole transport material (HTM) for regular PSCs. In the case of inverted PSCs, different HTLs have evolved from copper (CuI, $CuCrO_2$) and nickel (NiOx) compounds, and polymers such as (poly(3,4-ethylene dioxythiophene)polystyrene sulfonate (PEDOT:PSS) and poly[bis(4-phenyl)(2,5,6-trimethylphenyl)amine](PTAA)), to diverse organic small molecules, including the emerging self-assembled monolayers (SAMs).[7]

Self-assembled monolayers (SAMs) have recently emerged as a viable replacement for traditional charge transport layers in PSCs.[8] In particular, SAM molecules based on carbazole and phosphonic acid groups, usually referred to as nPACz, where n is the aliphatic chain length, have attracted great interest as hole-selective contacts. The carbazole group has a strong electron-donating moiety and thus hole-selective properties, while the phosphonic acid group can covalently bind to transparent conducting oxide (TCO) surfaces to form a monolayer.[7-9] Thanks to their fast hole extraction and the good electronic passivation of the SAMs/perovskite interfaces, perovskite-based pi-n single-junction and monolithic perovskite/silicon tandem solar cells achieved impressive PCEs of around 26.1% and 32.5%, respectively.[1]

While new SAMs are being intensely investigated towards hole collection for a range of perovskite photoabsorbers, reports towards the design of novel electron-selective SAM molecules remain rare. Arguably, this comes due to the relative scarcity of suitable electron acceptors, as used for electron-selecting material synthesis, and the required efforts towards identification and application of non-fullerene derivatives as electron-selective materials in PSCs.[11, 12] Generally, the class of organic ETLs is dominated by fullerene derivatives, including C60 and its functionalised analogues (e.g., $PC_{61}BM$, $PC_{71}BM$, etc.).[6,11,12] Nonetheless, the application of fullerene-based ETLs for solution processing is

limited by the poor solubility of unmodified fullerenes in organic solvents. Moreover, synthesizing and purifying modified fullerenes, particularly C70 derivatives, are challenging, necessitating complex and costly multistage processes.

As a non-fullerene alternative, naphthalene-diimide (NDI) based small molecules offer favourable ETL properties, such as high electron affinity, relatively high electron mobility, and photochemical stability with simple synthesis procedures.[6,13-15] Initially, NDI-based SAMs such as *N*,*N'*-bis(1-*n*-hexylpyridinium-4-ylmethyl)-1,4,5,8-naphthalenetetracarboxydiimide, and ammonium-bearing NDI polymer were applied as an interlayer between $PC_{61}BM$ and the metal electrode at the top contact to improve the performance of p-i-n PSCs.[13,16,17] Later, NDI-based SAMs, containing a carboxylic anchoring group, were applied directly onto indium-tin-oxide (ITO) substrates to modify their work function, enabling the collection of electrons in n-i-p PSCs.[18] These NDI-based devices demonstrated a PCE of 16 % with a fill factor (FF) of 70%. Whereas these results show potential, they lag behind the best performances of conventional n-i-p PSCs, relying typically on metal oxide ETLs (such as $TiO_2$ or $SnO_2$). Notably, the conventional solution-processed metal oxide ETL requires additional surface modifications with organic or inorganic materials to minimize interfacial charge losses, making challenging the scalability of PSC.

The present invention provides electron transporting NDI-based compounds functionalized with a phosphonic or phosphoric acid group to anchor directly onto transparent conductive oxides (ITO, FTO, etc.) with minimized thickness. Contrasting with conventional low-temperature processed metal-oxide ETLs that usually require a higher temperature processing (≥ 150 °C), these new electron-selective SAMs are solution processable requiring moderate temperatures (typically approx. 100 °C), which can be of benefit for certain applications of *n-i-p* PSCs with improved efficiency and stability. Furthermore, additional surface modifications with organic or inorganic materials to minimize interfacial charge losses, reduced material consumption are recently existing problems to be solved, especially with respect of the provision of scalable techniques. Additionally, such organic semiconductors are attractive not only for photovoltaics but also for the development of other low-cost, high-performance optoelectronic devices such as light emitting diodes, phototransistors, photocells, etc.

## SUMMARY OF THE INVENTION

The purpose of present invention is to provide new organic electron transporting naphthalene-diimide-based and naphthalene-imide-based compounds containing phosphonic or phosphoric acid as an anchoring group, allowing covalent binding to the transparent conducting oxide surface with suitable energetic levels, minimized thickness at low temperatures. Such compounds also more efficiently passivate a sensitizer layer (such as perovskite) of a photovoltaic device. Advantageously, the compounds of the present invention when used in optoelectronic and/or photoelectrochemical devices, offer multiple benefits to lower optical reflectance and energetic losses, simultaneously, compared to conventionally used $SnO_2$ ETL. In addition, the compounds of the present invention can be applied directly onto TCO substrates (such as, e.g. ITO substrates), and can be used as an alternative to or instead of conventional metal oxide (i.e., $SnO_2$, ZnO, and $TiO_2$) ETLs in, for example, n-i-p PSCs.

The present teachings also provide new electron transporting materials, which provide higher power conversion efficiency and stability.

Further aspects and preferred embodiments are detailed herein below and in the appended claims. Further features and advantages will become apparent to the skilled person from the description of the preferred embodiments given below.

## BRIEF DESCRIPTION OF THE DRAWINGS

**FIG. 1a** ) shows a schematic diagram of mesoporous n-i-p PSC device structure; **b)** planar n-i-p PSC device structure; **c)** p-i-n PSC device structure.

**FIG. 2a** ) shows UV-Vis spectra of electron transporting SAM material **V1264**; **b)** shows UV-Vis transmittance spectra of electron transporting material **V1264** and $SnO_2$ on the ITO substrate; **c)** shows UV-Vis reflectance spectra of electron transporting material **V1264** and $SnO_2$ on the ITO substrate.

**FIG. 3** shows TGA heating curve of DSC first and second heating curves of electron transporting material **V1264** (scan rate 10 °C/min, $N_2$ atmosphere).

**FIG. 4** shows redox voltamperograms of electron transporting material **V1264**.

**FIG. 5** shows water contact angle of ITO and ITO/ **V1264**.

**FIG. 6a** ) shows top-view of SEM image of perovskite on the bare-ITO; **b)** shows top-view of SEM image of perovskite on the **V1264** surface (scale bar 1 μm).

**FIG. 7a** ) shows cross-sectional SEM of bare-ITO; **b)** shows cross-sectional SEM of ITO/**V1264**.

**FIG. 8** shows a schematic diagram of the exemplary PSC device structure.

**FIG. 9** shows *J-V* characteristics of the ETM SAM compound **V1264** in PSCs devices.

**FIG. 10** shows the external quantum efficiency (EQE) spectra of ITO/$SnO_2$ and ITO/**V1264** based devices.

**FIG. 11** shows the statistical distribution of electron-selective SAMs from 25 devices.

**FIG. 12** shows summary of device's efficiency of electron-selective SAMs and ETL-free n-i-p devices from literature.

**FIG. 13** shows evolution of normalized PCEs for non-encapsulated devices based on $SnO_2$-ETL and electron transporting SAM material **V1264** at **a)** room temperature storage and **b)** 65 °C under nitrogen and dark conditions.

DETAILED DESCRIPTION OF THE INVENTION

The main object of the present teachings is new compounds of formula (I), (IV) or (V):

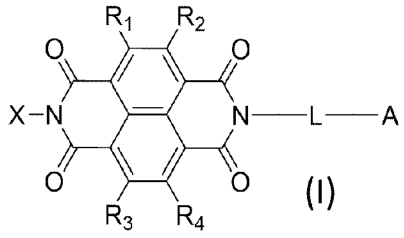
(I)

,

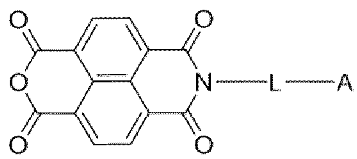
(IV),

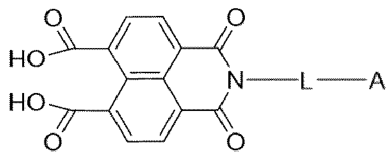
(V),

wherein

X is selected from -$L_1$-$A_1$, H, $NH_2$, $C_1$-$C_{10}$ alkyl, C2-C10 alkenyl, C2-C10 alkynyl, C4-C10 aryl, C4-C20 alkylaryl, C4-C20 alkenylaryl, and C4-C20 alkynylaryl, each of which is optionally substituted with C1-C10 alkyl, C2-C10 alkenyl, C2-C10 alkynyl, C1-C10 heteroalkyl, C4-C10 aryl, C2-C10 heteroalkenyl, C2-C10 heteroalkynyl, C4-C10 heteroaryl, or one or more heteroatoms selected from N, S and O;

$R_1$, $R_2$, $R_3$, $R_4$ is independently selected from H, CN, Cl, Br, F, $CF_3$, $NO_2$, C1-C20-alkyl, C2-20-perfluoroalkyl, C5-20-aryl, C5-20-heteroaryl;

A, $A_1$, $A_2$ is an anchoring group, and independently selected from phosphonic acid, monoalkyl ether of phosphonic acid, phosphoric acid, monoalkyl ether of phosphoric acid:

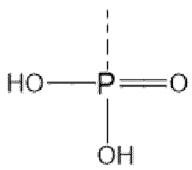
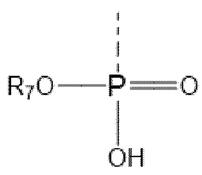
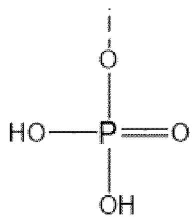
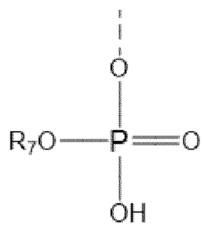

or a structure:

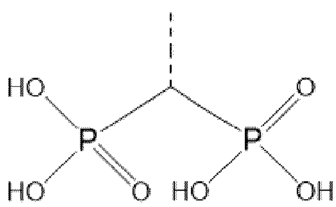

,

$R_7$ is C1-C9 alkyl group;

L, $L_1$ is a linking fragment and is independently selected from C1-C9 -alkylene, C4-C20 arylene, C4-C20 heteroarylene, C4-C20 alkylarylene, C4-C20 alkenarylene, C4-C20 heteroalkylarylene, C4-C20 heteroalkenarylene, wherein heteroatoms are selected from O, N, S, Se, Si, or from structure:

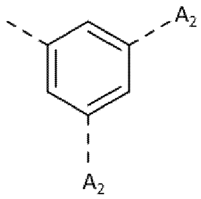

In embodiments where the compound of formula (I) comprises X selected from $C_1$-$C_{10}$ alkyl, C2-C10 alkenyl, C2-C10 alkynyl, said alkyl, alkenyl, alkynyl moieties, if they comprise 3 or more carbons, may be linear, branched or cyclic. In embodiments where the compound of formula (I) comprises X selected from $C_1$-$C_{10}$ alkyl, C2-C10 alkenyl, C2-C10 alkynyl, C4-C10 aryl, C4-C20 alkylaryl, C4-C20 alkenylaryl, and C4-C20 alkynylaryl, said alkyl, alkenyl, alkynyl, aryl, alkylaryl, alkenylaryl, alkynylaryl may be unsubstituted or substituted by C1-C10 alkyl, C2-C10 alkenyl, C2-C10 alkynyl, C1-C10 heteroalkyl, C4 to C10 aryl, C2-C10 heteroalkenyl, C2-C10 heteroalkynyl, C4 to C10 heteroaryl, or one or more heteroatoms being selected from N, S and O.

In embodiments where the compound of formula (I) comprises L, $L_1$ independently selected from C1-C9 -alkylene, C4-C20 arylene, C4-C20 heteroarylene, C4-C20 alkylarylene, C4-C20 alkenarylene, C4-C20 heteroalkylarylene, C4-C20 heteroalkenarylene, wherein heteroatoms are selected from O, N, S, Se, Si, or from structure:

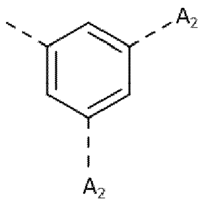

said alkylene, arylene, heteroarylene, alkylarylene, heteroalkylarylene, if they comprise 3 or more carbon atoms, may be linear, branched or cyclic, e.g.,

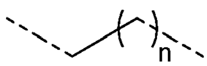

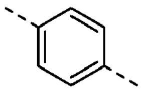

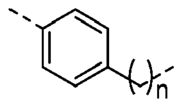

The term "alkylene" as used herein, represent a saturated divalent hydrocarbon group derived from a straight or branched chain saturated hydrocarbon by the removal of two hydrogen atoms, and is exemplified by methylene, ethylene, and isopropylene. Accordingly, "arylene", "heteroarylene", "alkylarylene", "alkenarylene", "heteroalkylarylene" as used herein, represent a respective divalent group (aryl, heteroaryl, alkylaryl, alkenaryl, heretoalkylaryl, respectively) that is derived by the removal of two hydrogen atoms. As used herein, the term "C4-C20 heteroalkenarylene", in cases wherein heteroatoms are selected from N, is understood to include the structures such as:

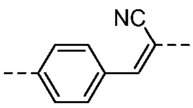

In preferred embodiment, the compound is according to formula (I). In some embodiments, the compound of formula (I) may comprise X that is -$L_1$-$A_1$, wherein $L_1$ is the same as L, A1 is the same as A; such compounds provide electron transporting naphthalenediimide-based SAM compounds of symmetrical structure. In other embodiments, the compound of formula (I) comprises X that does not have the same structure as -L-A; such compounds provide electron transporting naphthalenediimide-based SAM compounds of asymmetrical structure.

According to another embodiment, the naphthalene-diimide-based compounds of formula (**I**) contain phosphonic acid as an anchoring group, allowing covalent binding to the transparent conducting oxide surface, are electron transporting materials selected from, but not limited to, a compound according to any one of formulae (1) to (35), (37) to

(82).

In some embodiments, the naphthalene-diimide-based compounds of formula (**I**) contain phosphoric acid as an anchoring group, for example, a compound of formula (36).

*Symmetric structures of exemplary compounds of formula (I):*

| (**1, V1612**) | (**2, V1625**) |
|---|---|
| 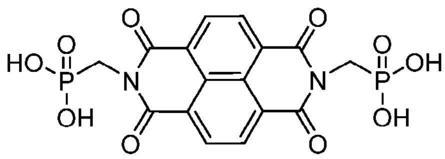 | 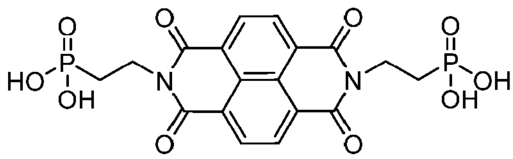 |
| (**3**) | (**4**) |
| 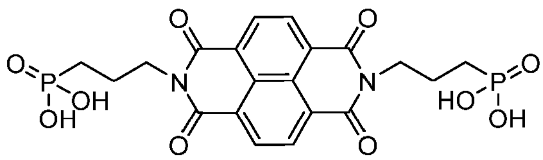 | 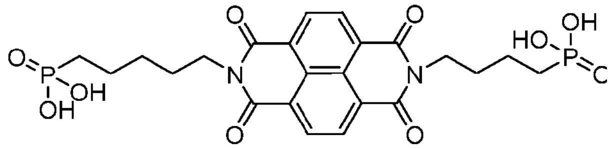 |
| (**5, V1486**) | (**6**) |
| 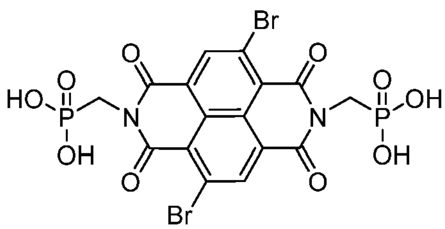 | 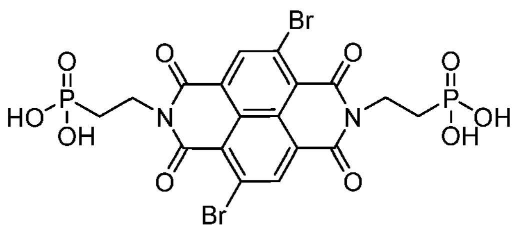 |
| (**7**) | (**8**) |
| 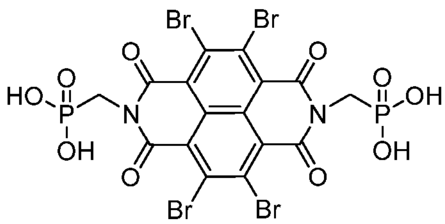 | 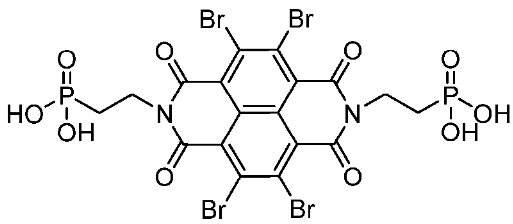 |
| (**9**) | (**10**) |
| 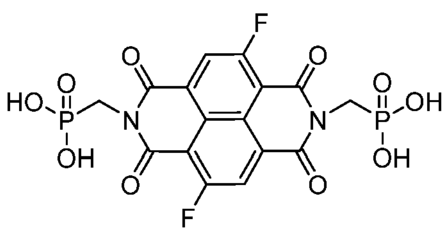 | 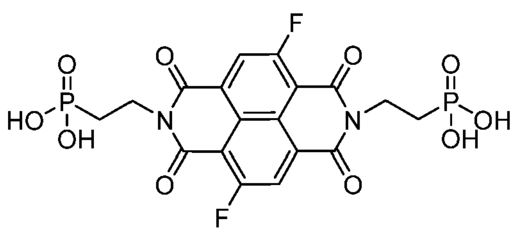 |
| (**11**) | (**12**) |

(continued)

| | |
|---|---|
| 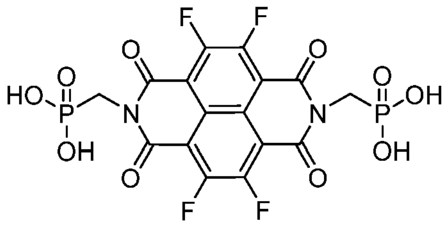 | 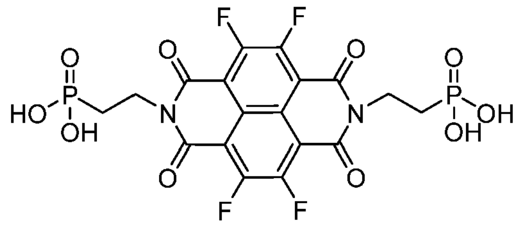 |

| (**13**) | (**14**) |
|---|---|
| 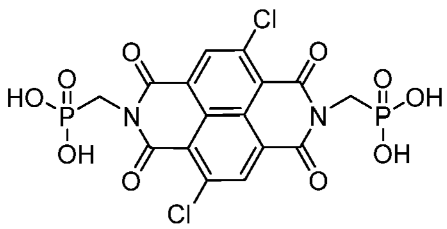 | 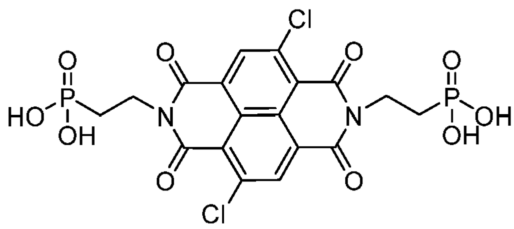 |
| (**15**) | (**16**) |
| 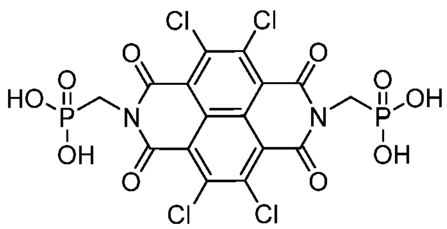 | 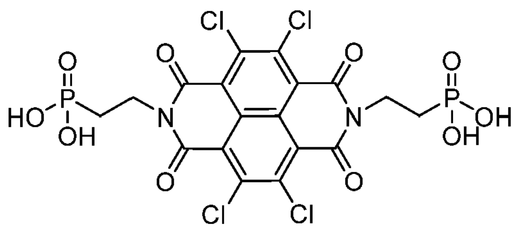 |
| (**17**) | (**18**) |
| 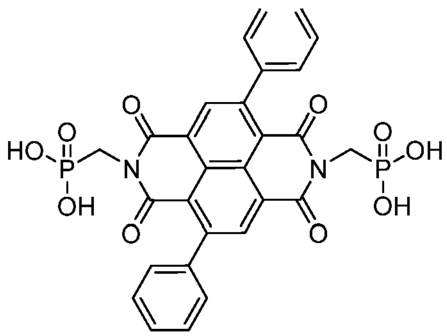 | 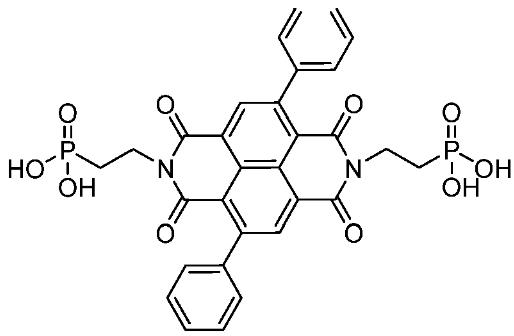 |
| (**19**) | (**20**) |
| 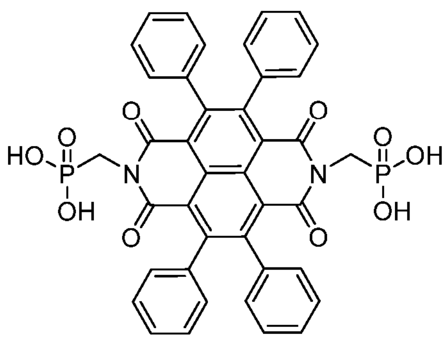 | 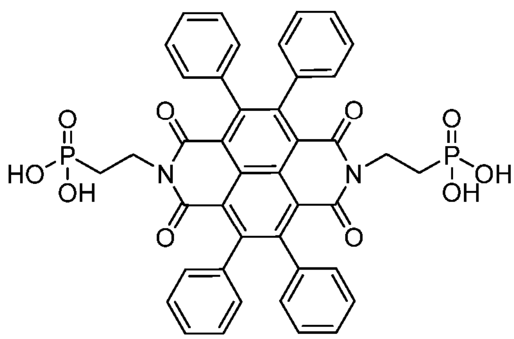 |
| (**21**) | (**22**) |

(continued)

| | |
|---|---|
| 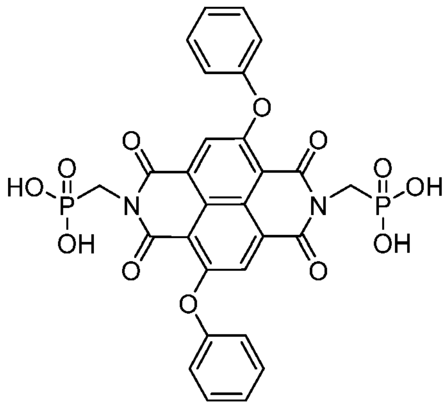 | 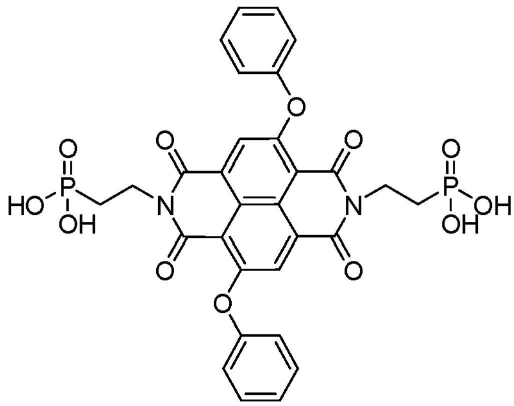 |

| | |
|---|---|
| (23) | (24) |
| 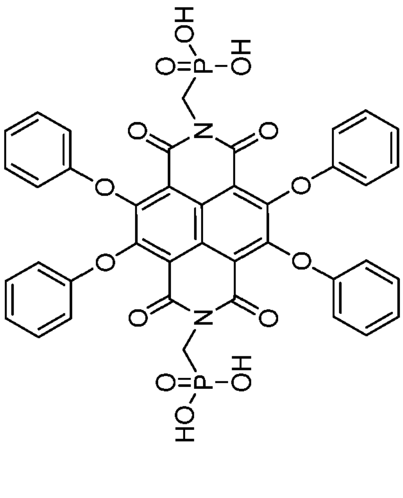 | 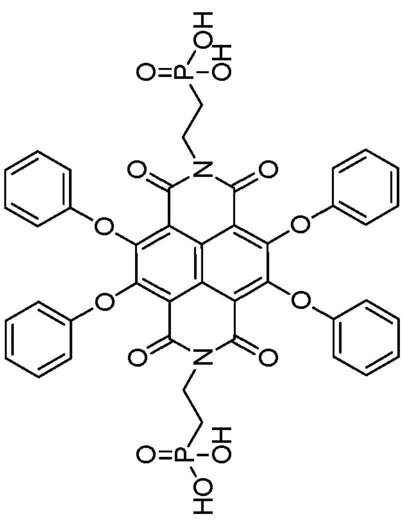 |
| (25) | (26) |
| 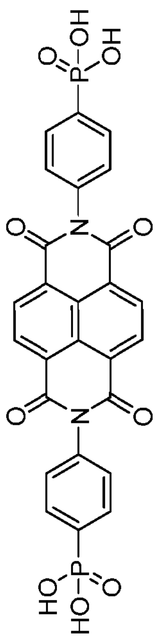 | 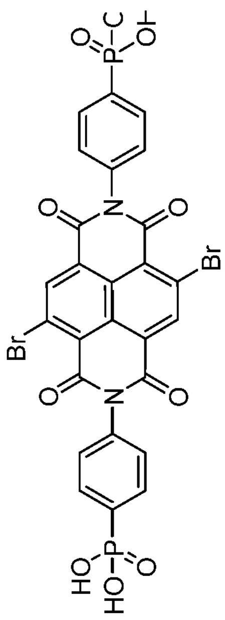 |
| (27) | (28) |
| 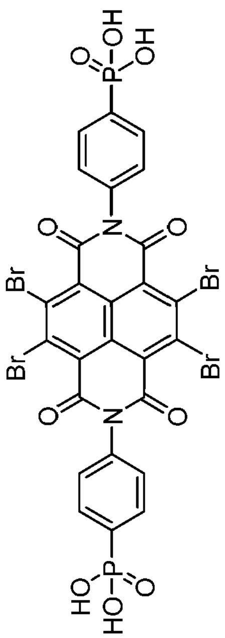 | 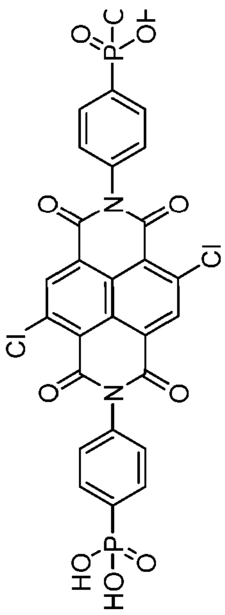 |
| (29) | (30) |

(continued)

| | |
|---|---|
| 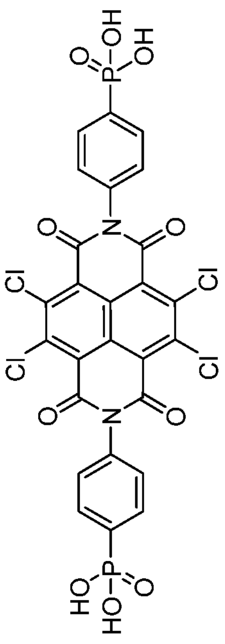 | 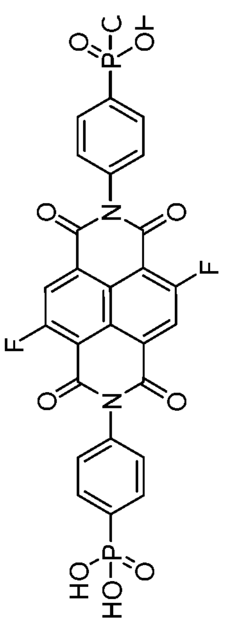 |
| (31) | (32) |
| 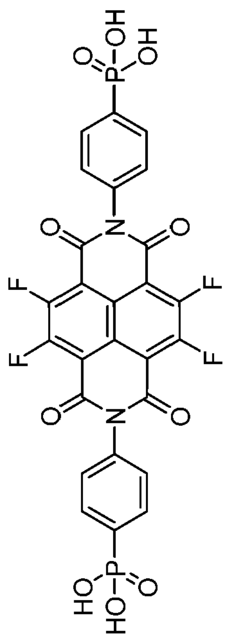 | 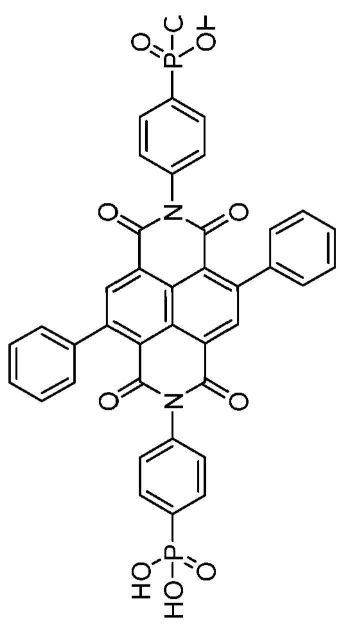 |

| | | | |
|---|---|---|---|
| (33) | 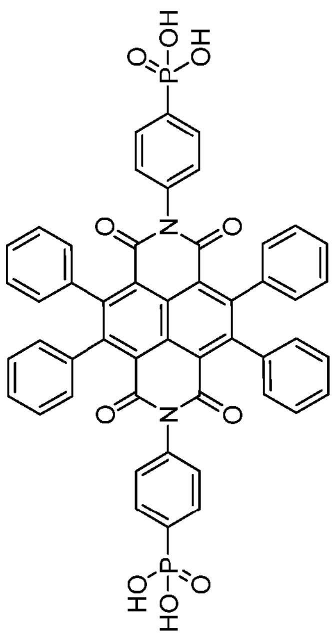 | (34) | 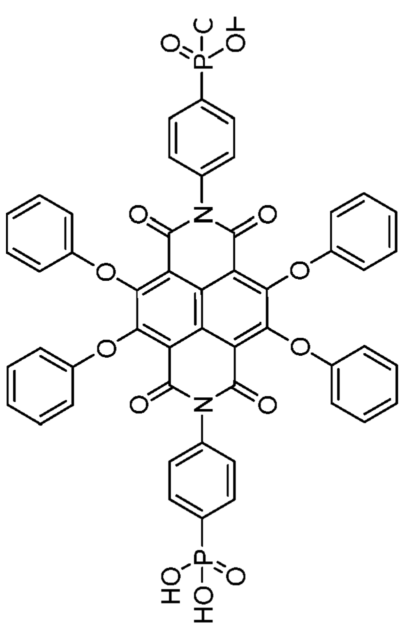 |
| (35) | 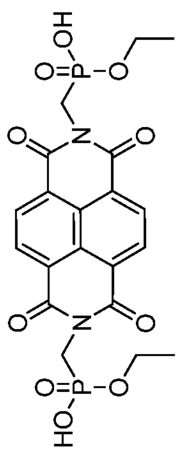 | (36) | 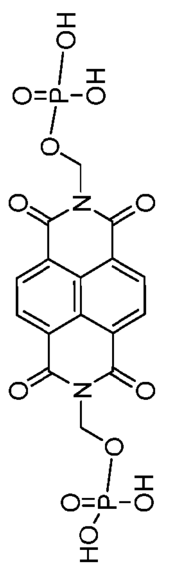 |
| (37) | 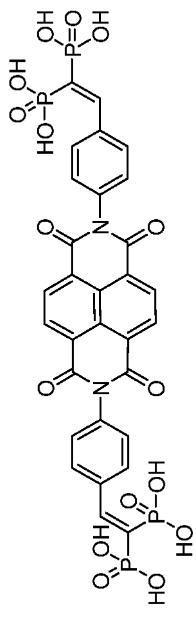 | (38) | 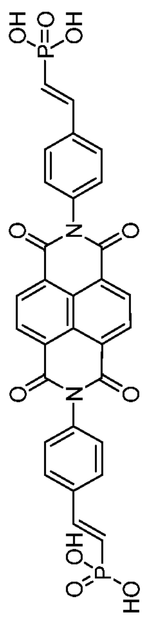 |
| (39) | 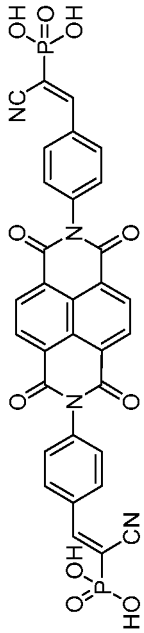 | | |

*Asymmetric structures of exemplary compounds of formula (I):*

| (**40**) | (**41, V1264**) |
|---|---|
| 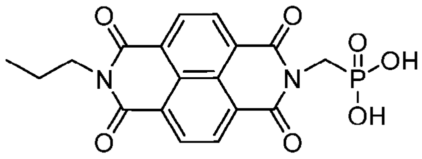 | 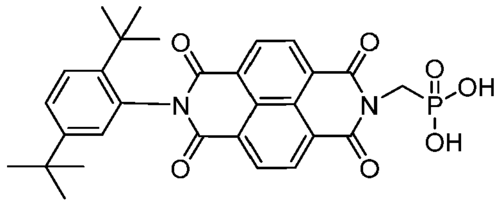 |
| (**42**) | (**43, V1624**) |
| 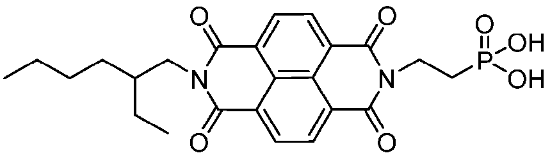 | 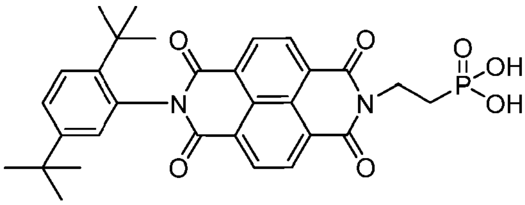 |

| (**44**) | (**45**) |
|---|---|
| 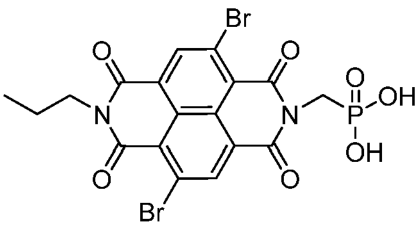 | 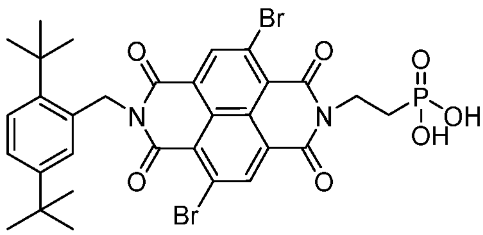 |
| (**46**) | (**47**) |
| 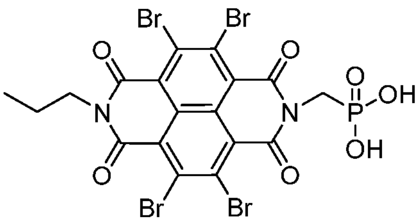 | 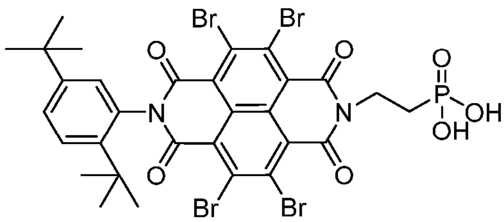 |
| (**48**) | (**49**) |
| 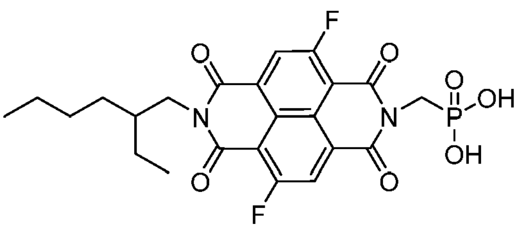 | 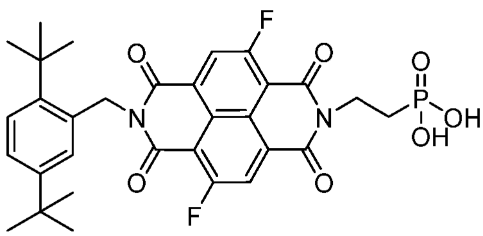 |
| (**50**) | (**51**) |

(continued)

| | |
|---|---|
| 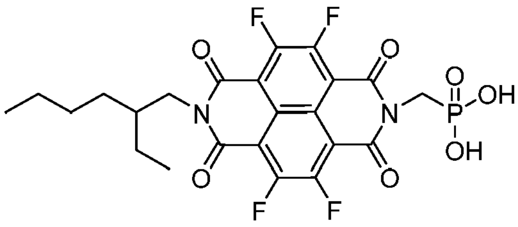 | 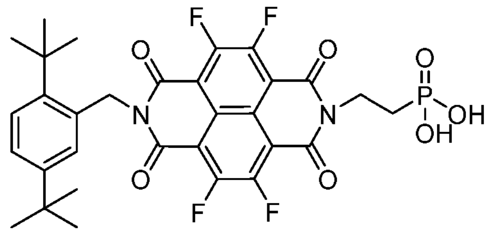 |
| (**52**) | (**53**) |
| 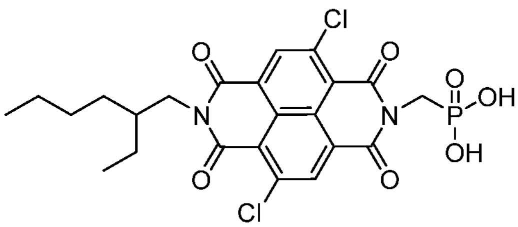 | 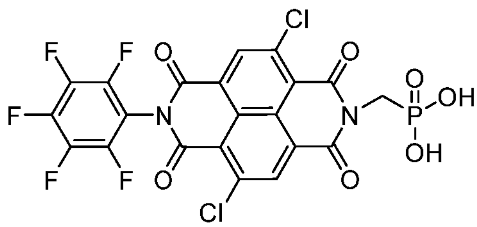 |
| (**54**) | (**55**) |
| 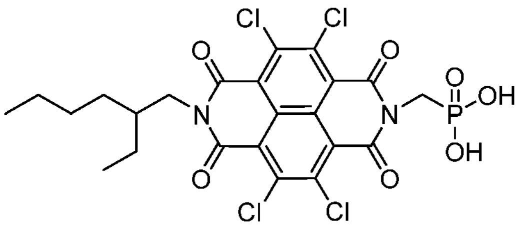 | 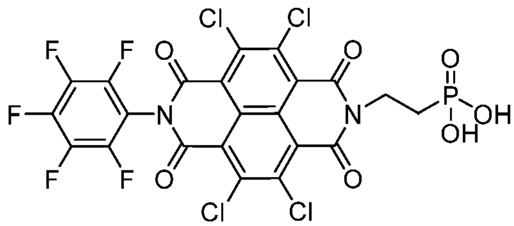 |
| (**56**) | (**57**) |
| 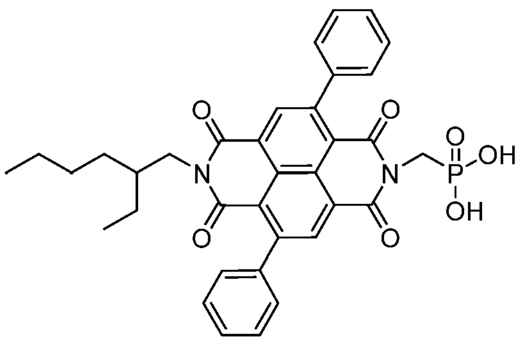 | 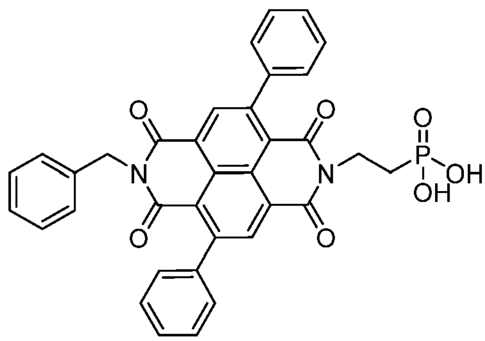 |
| (**58**) | (**59**) |
| 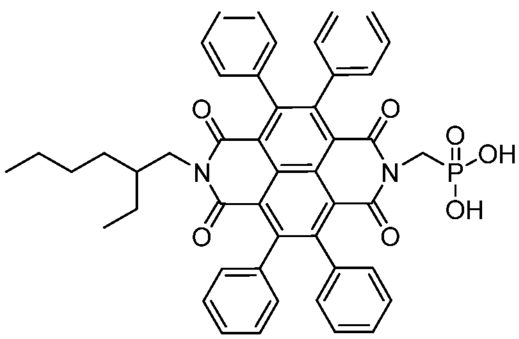 | 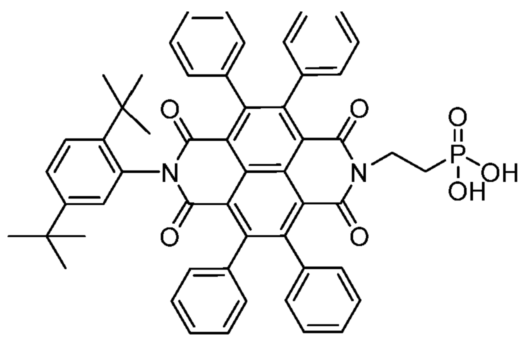 |
| (**60**) | (**61**) |

(continued)

| | |
|---|---|
| 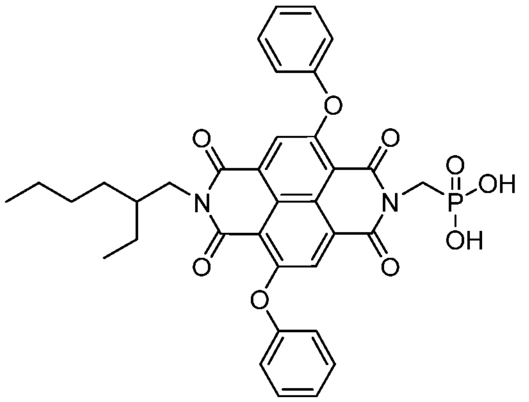 | 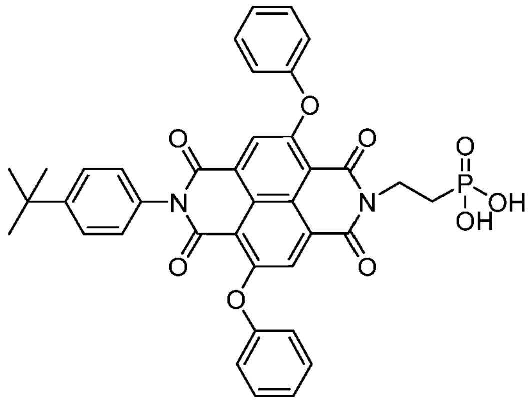 |
| (**62**) | (**63**) |
| 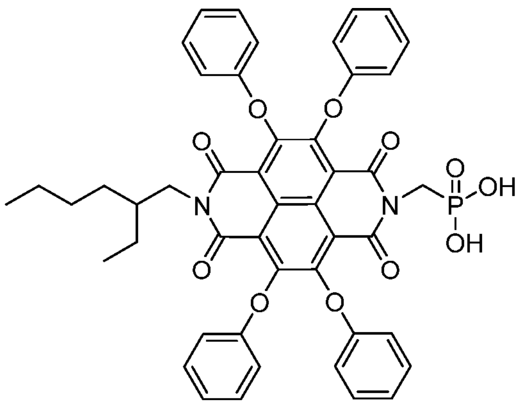 | 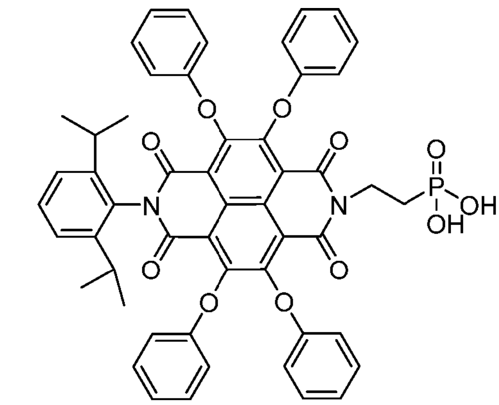 |

| | |
|---|---|
| (**64**) | (**65**) |
| 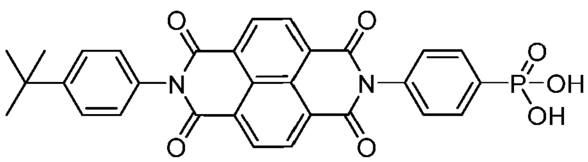 | 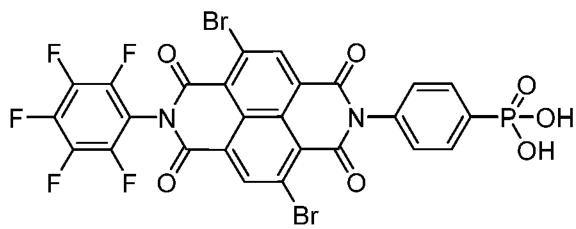 |
| (**66, V1635**) | |
| 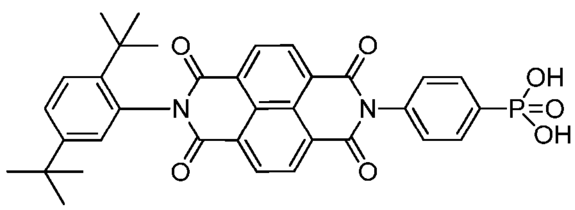 | |
| (**67**) | (**68**) |
| 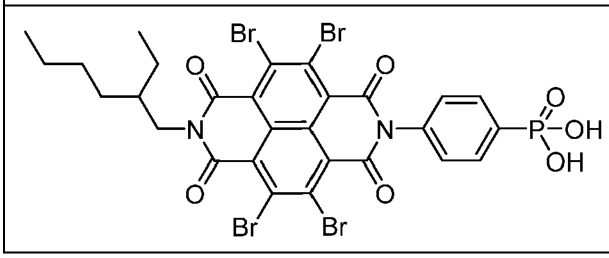 | 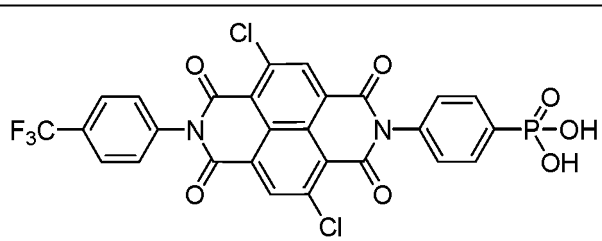 |

(continued)

| | |
|---|---|
| (**69**) | (**70**) |
| 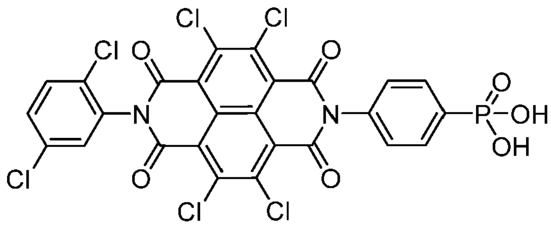 | 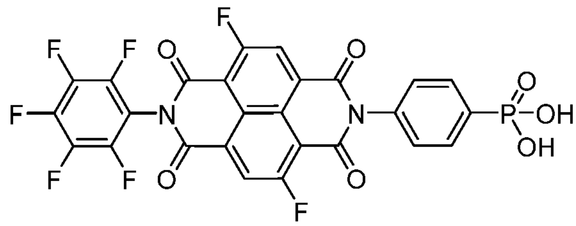 |
| (**71**) | (**72**) |
| 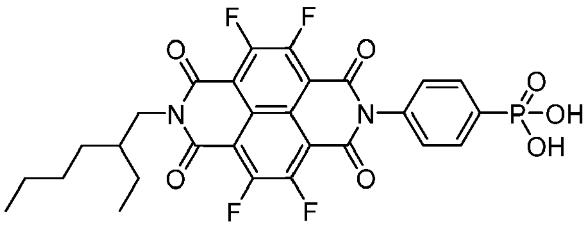 | 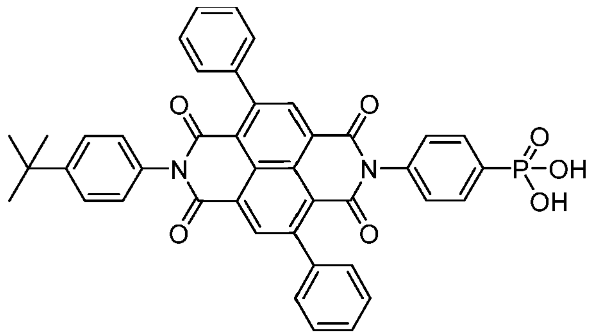 |

| | |
|---|---|
| (**73**) | (**74**) |
| 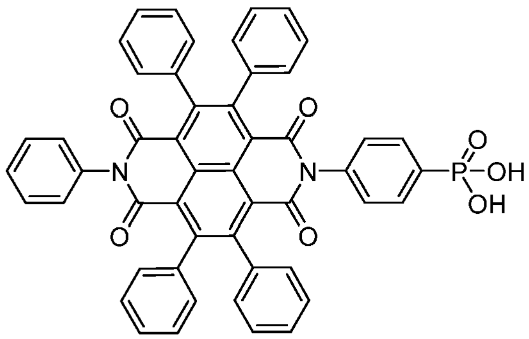 | 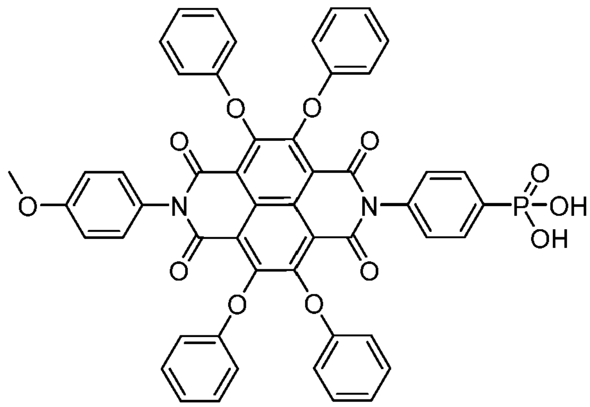 |
| (**75**) | (**76**) |
| 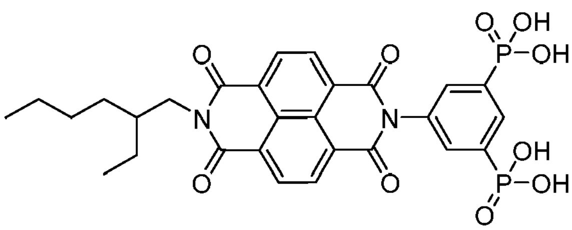 | 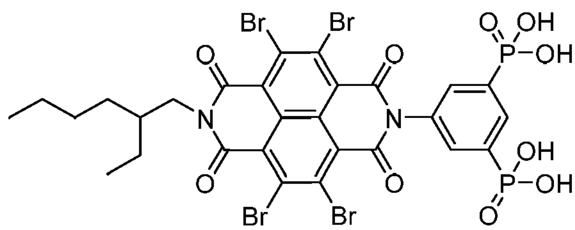 |
| (**77**) | (**78**) |
| 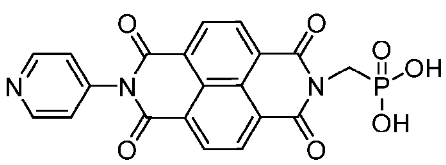 | 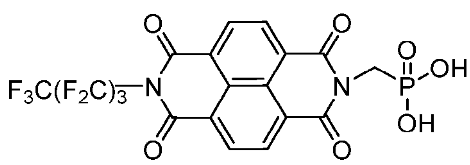 |
| (**79**) | (**80**) |

(continued)

| 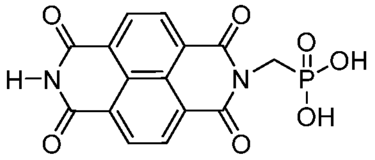 | 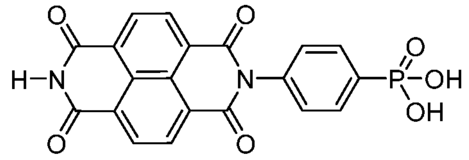 |
|---|---|
| (**81**) | (**82**) |
| 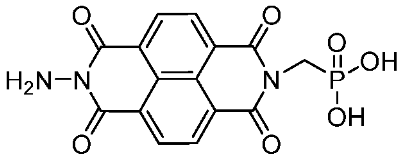 | 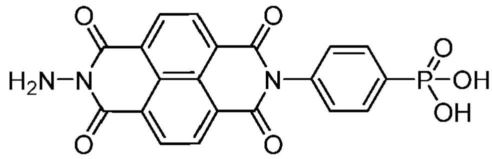 |

In some embodiments, the compounds of formula (I) wherein $R_2$ and $R_3$, or $R_1$ and $R_4$ are the same and are selected from CN, Cl, Br, F, $CF_3$, $NO_2$, C1-C20-alkyl, C2-20-perfluoroalkyl, C5-20-aryl, C5-20-heteroaryl, are preferred, as the electronegativity of the compound is increased.

In some embodiments, the compound of formula (I) is provided, wherein each of $R_1$, $R_2$, $R_3$, $R_4$ is H, and/or each of A, A1 is phosphonic acid. In such cases, the compound may further comprise L, L1 that is independently selected from C3-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si. In particular, for example in cases where the compound of formula (I) comprises each of $R_1$, $R_2$, $R_3$, $R_4$ that is H, A, $A_1$ is phosphonic acid, L, $L_1$ is not methylene or ethylene.

In some embodiments, the compound of formula (I) is provided, wherein:

X is selected from -$L_1$-$A_1$,
$R_1$, $R_2$, $R_3$, $R_4$ is independently selected from H, CN, Cl, Br, F, $CF_3$, $NO_2$, C1-C20-alkyl, C2-20-perfluoroalkyl, C5-20-aryl, C5-20-heteroaryl;
A, $A_1$, $A_2$ is an anchoring group, and independently selected from phosphonic acid, monoalkyl ether of phosphonic acid, phosphoric acid, monoalkyl ether of phosphoric acid:

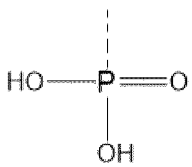 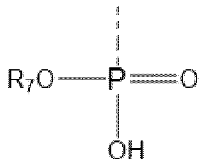 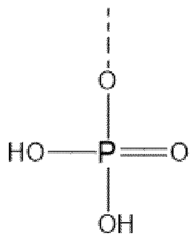 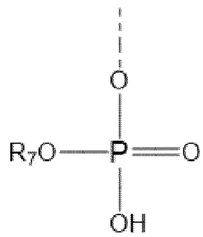

or a structure:

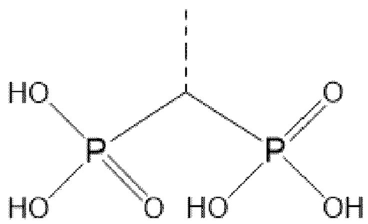

,

$R_7$ is C1-C9 alkyl group;
L, $L_1$ is a linking fragment and is independently selected from C1-C9 -alkylene, C4-C20 arylene, C4-C20 heteroarylene, C4-C20 alkylarylene, C4-C20 alkenarylene, C4-C20 heteroalkylarylene, C4-C20 heteroalkenarylene, wherein heteroatoms are selected from O, N, S, Se, Si, or from structure:

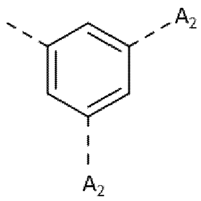

.

In some embodiments, such compound comprises A, $A_1$, $A_2$ that is phosphonic acid.
In some embodiments, such compound comprises A, $A_1$ that is phosphoric acid.
In some embodiments, where the compound of formula (I) comprises X selected from $-L_1-A_1$, linking fragments L and $L_1$ are the same.
In some embodiments, the compound of formula (I) comprises X that is $-L_1-A_1$,

$R_1$, $R_2$, $R_3$, $R_4$ is independently selected from H, CN, Cl, Br, F, $CF_3$, $NO_2$, C1-C20-alkyl, C2-20-perfluoroalkyl, C5-20-aryl, C5-20-heteroaryl,
the linking fragments L and L1 are the same and are selected from C1-C9 -alkylene, C4-C20 arylene, C4-C20 heteroarylene, C4-C20 alkylarylene, C4-C20 alkenarylene, C4-C20 heteroalkylarylene, C4-C20 heteroalkenarylene, wherein heteroatoms are selected from O, N, S, Se, Si, or from structure:

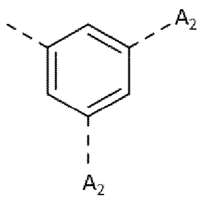

,

and anchoring A, $A_1$, $A_2$ anchoring groups are the same and are phosphonic acid. The exemplary compounds of such structure are the compounds of structures 1 to 39, preferably, the compounds of structures 5 to 39.

In further embodiments, the compound according to formula (I) is provided, wherein X is selected from H, $NH_2$, C1-C10 alkyl, C2-C10 alkenyl, C2-C10 alkynyl, C4-C10 aryl, C4-C20 alkylaryl, C4-C20 alkenylaryl, and C4-C20 alkynylaryl, each of which is optionally substituted with C1-C10 alkyl, C2-C10 alkenyl, C2-C10 alkynyl, C1-C10 heteroalkyl, C4-C10 aryl, C2-C10 heteroalkenyl, C2-C10 heteroalkynyl, C4-C10 heteroaryl, or one or more heteroatoms selected from N, S and O. Such compounds may have additional advantage of increased solubility in organic solvents, and are therefore more convenient to work with. The exemplary compounds of such structure are the compounds of structures 40 to 78.
In some embodiments, the compound of formula (I) is provided, wherein X is selected from C4-C20 alkylaryl optionally substituted with C1-C10 alkyl. Such compounds, when used in photovoltaic devices, may provide improved interaction with the sensitizer layer of the photovoltaic device. For example, such compound may have a structure as provided in structures 41, 43, 45, 47, 49, 51, 59, 61, 63, 64, 66, 72.
Tables 1 and 2 present some further non-limiting examples of compounds of formula (I) of the invention.

Table 1. Examples of symmetric compounds of formula (I) of the invention

| No. | $R_1$, R4 | R2, R3 | A, A1, A2 | L, L1 |
|---|---|---|---|---|
| 87 | H | H | Phosphonic acid | C3-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si, or structure: 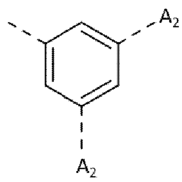 |

(continued)

| No. | $R_1$, R4 | R2, R3 | A, A1, A2 | L, L1 |
|---|---|---|---|---|
| 88 | H | H | Phosphoric acid | C1-C9-alkylene, C4-C20 arylene, C4-C20 heteroarylene, C4-C20 alkylarylene, heteroalkylarylene, C4-C20 C4-C20 heteroalkenarylene,<br>wherein heteroatoms are selected from O, N, S, Se, Si, or structure: 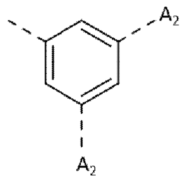 |
| 89<br>90<br>91 | H | Br<br>F<br>Cl | Phosphonic acid | C1-C9 -alkylene, C4-C20 arylene, C4-C20 heteroarylene, C4-C20 alkylarylene, C4-C20 heteroalkylarylene, C4-C20 heteroalkenarylene,<br>wherein heteroatoms are selected from O, N, S, Se, Si, or structure: 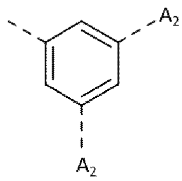 |
| 92 | Br | Br | | |
| 93 | F | F | | |
| 94 | Cl | Cl | | |
| 95 | H | phenyl | | |
| 96 | phenyl | phenyl | | |
| 97 | H | phenoxy | | |
| 98 | phenoxy | phenoxy | | |
| 99 | H | H | Phosphonic acid | C4-C20 arylene, C4-C20 heteroarylene, C4-C20 alkylarylene, C4-C20 heteroalkylarylene,<br>C4-C20 heteroalkenarylene, wherein heteroatoms are selected from O, N, S, Se, Si, or structure: 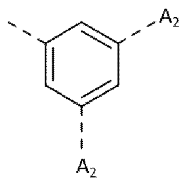 |
| 100<br>101<br>102 | H | Br<br>F<br>Cl | | |
| 103 | Br | Br | | |
| 104 | F | F | | |
| 105 | Cl | Cl | | |
| 106 | H | phenyl | | |
| 107 | phenyl | phenyl | | |
| 108 | H | phenoxy | | |
| 109 | phenoxy | phenoxy | | |

Table 2. Examples of asymmetric compounds of formula (I) of the invention

| No. | X | R1, R4 | R2, R3 | A, A2 | L |
|---|---|---|---|---|---|
| 110 | C4-C20 alkylaryl optionally substituted with C1-C10 alkyl | H | H | Phosphonic acid | methylene |
| 111 | | H | H | | ethylene |
| 112 | | H | H | | phenylene |

(continued)

| No. | X | R1, R4 | R2, R3 | A, A2 | L |
|---|---|---|---|---|---|
| 113<br>114<br>115 | C4-C20 alkylaryl optionally substituted with C1-C10 alkyl | H | Br<br>F<br>Cl | Phosphonic acid | methylene |
| 116<br>117<br>118 | | H | Br<br>F<br>Cl | | ethylene |
| 119<br>120<br>121 | | H | Br<br>F<br>Cl | | phenylene |
| 122 | C4-C20 alkylaryl optionally substituted with C1-C10 alkyl | Br | Br | Phosphonic acid | methylene |
| 123 | | Br | Br | | ethylene |
| 124 | | Br | Br | | phenylene |
| 125 | C4-C20 alkylaryl optionally substituted with C1-C10 alkyl | F | F | Phosphonic acid | methylene |
| 126 | | F | F | | ethylene |
| 127 | | F | F | | phenylene |
| 128 | C4-C20 alkylaryl optionally substituted with C1-C10 alkyl | Cl | Cl | Phosphonic acid | methylene |
| 129 | | Cl | Cl | | ethylene |
| 130 | | Cl | Cl | | phenylene |
| 131 | C4-C20 alkylaryl optionally substituted with C1-C10 alkyl | H | phenyl | Phosphonic acid | methylene |
| 132 | | H | phenyl | | ethylene |
| 133 | | H | phenyl | | phenylene |
| 134 | C4-C20 alkylaryl optionally substituted with C1-C10 alkyl | phenyl | phenyl | Phosphonic acid | methylene |
| 135 | | phenyl | phenyl | | ethylene |
| 136 | | phenyl | phenyl | | phenylene |
| 137 | C4-C20 | H | phenoxy | Phosphonic | methylene |
| No. | X | R1, R4 | R2, R3 | A, A2 | L |
| 138 | alkylaryl optionally substituted with C1-C10 alkyl | H | phenoxy | acid | ethylene |
| 139 | | H | phenoxy | | phenylene |
| 140 | C4-C20 alkylaryl optionally substituted with C1-C10 alkyl | phenoxy | phenoxy | Phosphonic acid | methylene |
| 141 | | phenoxy | phenoxy | | ethylene |
| 142 | | phenoxy | phenoxy | | phenylene |

(continued)

| No. | X | R1, R4 | R2, R3 | A, A2 | L |
|---|---|---|---|---|---|
| 143 | 2-ethylhexyl | H | H | Phosphonic acid | C1-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si, or structure: 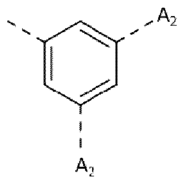 |
| 144<br>145<br>146 | | H | Br<br>F<br>Cl | | |
| 147 | | Br | Br | | |
| 148 | | F | F | | |
| 149 | | Cl | Cl | | |
| 150 | | H | phenyl | | |
| 151 | | phenyl | phenyl | | |
| 152 | | H | phenoxy | | |
| 153 | | phenoxy | phenoxy | | |
| 154 | propyl | H | H | Phosphonic acid | |
| 155<br>156<br>157 | | H | Br<br>F<br>Cl | | |
| 158 | | Br | Br | | |
| 159 | | F | F | | |
| 160 | | Cl | Cl | | |
| 161 | | H | phenyl | | |
| 162 | | phenyl | phenyl | | |
| 163 | | H | phenoxy | | |
| 164 | | phenoxy | phenoxy | | |

In Table 1 and 2, each row numbered with a specific No. denotes an exemplary compound or group of compounds of formula (I) where specific values of X, R1, R2, R3, R4, A, A1, A2, L, L1. For example, row "No. 90" shows compound of formular (I), where R1 and R4 are both H, R2 and R3 are both F, A, A1, A2 are phosphonic acid, and L, L1 are the same and are selected from C1-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si, or structure.

Similarly, it will be understood that, e.g., row "No. 150" is shows compound where X is 2-ethylhexyl, R1 and R4 are both H, R2 and R3 are both phenyl, A, A2 are phosphonic acid, and L, L1 are the same and are selected from C1-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si, or structure.

*Examples of the structures of compounds of formula (IV) or (V):*

| (83) | (84) |
|---|---|
| 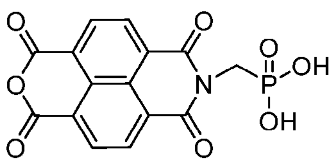 | 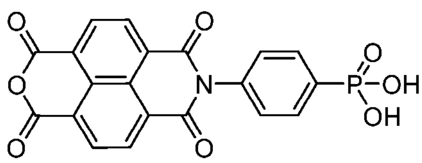 |
| (85) | (86) |

(continued)

| | |
|---|---|
| 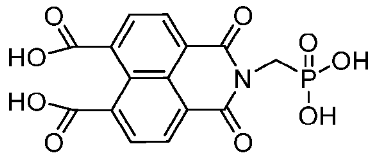 | 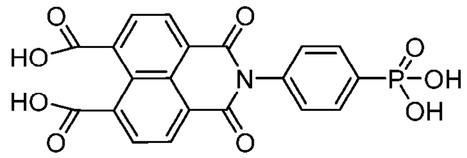 |

In yet further embodiments, the invention provides an electron transporting material comprising one or more of the aforementioned compounds of formula (I). Said compounds of the general formula (**I**) are for use as an organic non-polymeric semiconductor. More specifically, the invention provides electron transporting material comprised of at least one compound of the general formula (**I**).

In some embodiments, a composition comprising one or more compounds of the formula (**I**) is provided.

In further embodiments, the invention provides an electron transporting material comprising one or more of the aforementioned compounds of formula (IV) or (V). In some embodiments, a composition comprising one or more compounds of the formula (IV) or (V)is provided.

In some embodiments, the composition further comprises a filler molecule (FM), wherein FM is at least one kind of molecule consisting of an anchoring group, an alkyl chain of N carbon atoms, with N is in the range of 1 to 18, and a functional group of at least on of the group methyl, halogen, amino, bromide, ammonium and sulfuric functional group.

In further embodiments, an optoelectronic and/or photoelectrochemical device comprising an electron transporting layer comprising the compound of formula (I) is provided. In other embodiments, an optoelectronic and/or photoelectrochemical device comprising an electron transporting layer comprising the composition that comprises one or more compounds of formula (I) is provided.

As provided herein, the optoelectronic and/or photoelectrochemical device may be selected from a photovoltaic device, an organic photovoltaic device, a photovoltaic solid state device, an organic solar cell, a solid state solar cell, a perovskite solar cell, a tandem solar cell, a light emitting electrochemical cells, and OLED. A p-n heterojunction, a dye sensitized solar cell may be provided as further examples of such devices.

In some embodiments, the photovoltaic device that comprises electron transporting material comprising a compound of formula (I) is a tandem solar cell, preferably wherein the tandem solar cell comprises at least one perovskite solar cell. Tandem solar cell are photovoltaic devices, that comprise multiple (two or more) stacked photovoltaic sub-cells, that can either be individual cells (mechanically stacked), or electrically interconnected integrated into one device. At least one of the sub-cells - perovskite solar cell (based on perovskite semiconductor). Examples are: perovskite/silicon; perovskite/CIGS; perovskite/perovskite; organic/perovskite etc. Tandems, comprising two photovoltaic sub-cells can be four terminal, two terminal and three terminal. The goal of the formation of the tandem devices is more efficient utilization of solar spectra, due to the optimized and complementary absorption of the electromagnetic radiation by different semiconductors. As provided herein, the compounds of the present invention or compositions comprising said compounds can serve as an electron transporting material in at least one of the perovskite sub-cell of a tandem solar cell.

In some embodiments, the optoelectronic and/or photoelectrochemical device is a photovoltaic device, preferably the device is a photovoltaic cell. In some embodiments, a photovoltaic device, for example, a photovoltaic cell, comprising a conducting support layer covered with electron transporting layer, a sensitizer layer, a hole transporting layer, and a counter electrode, wherein the electron transporting layer comprises the compound according to formula (I) is provided. In some embodiments, the electron transporting layer comprises the composition comprising one or more compounds according to formula (I) and, optionally, a filler molecule. In some embodiments, the optoelectronic and/or photoelectrochemical device is a photovoltaic device, preferably the device is a photovoltaic cell. In some embodiments, a photovoltaic device, for example, a photovoltaic cell, comprising a conducting support layer covered with electron transporting layer, a sensitizer layer, a hole transporting layer, and a counter electrode, wherein the electron transporting layer comprises the compound according to formula (IV) or (V) is provided. In some embodiments, the electron transporting layer comprises the composition comprising one or more compounds according to formula (IV) or (V) and, optionally, a filler molecule.

In some embodiments, the photovoltaic device comprises the electron transporting layer that is comprised of compound according to formula (I). In some embodiments, the photovoltaic device comprises only the electron transporting layer that is comprised of compound according to formula (I). That is, in such a device electron transport materials or electron transport layers other than the compound of the present invention may not be needed - the compounds of the present invention can be applied directly onto TCO substrates, and can be used as an alternative to or instead of conventional metal oxide (i.e., $SnO_2$, ZnO, and $TiO_2$) ETLs. In some embodiments, the photovoltaic device comprises the electron transporting layer that consists of compound according to formula (I). In some embodiments, the electron transporting layer consists of the composition comprising one or more compounds according to formula (I) and, optionally, a filler molecule.

The conducting support layer of the photovoltaic device is preferably substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example. The conducting support layer preferably functions and/or comprises a current collector, collecting the current obtained from the photovoltaic solid-state device. The conducting support layer may comprise a conducting material selected from indium-doped tin oxide (ITO), indium zinc oxide (IZO), fluorine doped tin oxide (FTO), a metal, and/or other conductors, preferably coated on transparent substrate, such as plastic or glass. In this case, the plastic or glass provides the support structure of the layer, and the cited conducting material provides the conductivity. Such support layers are generally known as conductive glass and conductive plastic, respectively, and are preferred conducting support layers in accordance with the invention.

According to some embodiments, the sensitizer layer of the photovoltaic device comprises at least one pigment being selecting from organic, inorganic, organometallic, organic-inorganic pigments, or a combination thereof. The sensitizer is preferably a light absorbing compound or material. Preferably, the sensitizer is a pigment, and most preferably the sensitizer is an organic-inorganic pigment.

According to the preferred embodiment, the electron transporting layer comprising a compound of formula (**I**) is coated by a layer comprising a sensitizer. Preferably said sensitizer layer comprises an organic-inorganic perovskite.

In some embodiments, the electron transporting layer comprising a compound of formula (IV) or (V) is coated by a layer comprising a sensitizer

According to the preferred embodiment, the sensitizer or the sensitizer layer comprises, consists of, or is made of an organic-inorganic perovskite. Said organic-inorganic perovskite is provided under a film of one perovskite pigment or mixed perovskite pigments or perovskite pigments mixed with further dyes or sensitizers.

According to a further embodiment, the sensitizer layer comprises another pigment in addition to the organic-inorganic perovskite pigment, said another pigment selected from organic pigment, organometallic pigment, or inorganic pigment.

According to another embodiment, the optoelectronic and/or photoelectrochemical device is a dye sensitized solar cell (DSC) comprising a compound of formula (**I**) as electron transporting material and a pigment as sensitizer selected from organic pigment, organometallic pigment, inorganic pigment, or a combination thereof.

The term "perovskite", for the purpose of this specification, refers to the "perovskite structure" and not specifically to the perovskite material, $CaTiO_3$. For the purpose of this specification, "perovskite" encompasses and preferably relates to any material that has the same type of crystal structure as calcium titanium oxide and of materials in which the bivalent cation is replaced by two separate monovalent cations. The perovskite structure has the general stoichiometry $AMX_3$, where "A" and "M" are cations and "X" is an anion. The "A" and "M" cations can have a variety of charges, for instance, in the original Perovskite mineral ($CaTiO_3$), the A cation is divalent and the M cation is tetravalent.

In a further embodiment, the organic-inorganic perovskite layer material comprises a perovskite-structure of formula (**II**):

$$AMX_3 \qquad (\mathbf{II})$$

wherein

A is an alkali metal ion, preferably $Li^+$, $Na^+$, $K^+$, $Rb^+$, $Cs^+$; ammonium or amidinium ion, wherein one or more hydrogens are substituted by alkyl or acyl group. Said ammonium ions, including mono, di, tri and tetra alkyl ammonium ions, wherein one or more hydrogens are substituted by alkyl group. Preferably, the substituent is alkyl group or groups independently selected from C1-C6, preferably methyl or ethyl groups. Said ammonium ions, N-alkyl amidinium and imidinium ions, wherein one or more hydrogens are substituted by alkyl group. Preferably, the amidinium or imidinium ions are selected from C1-C6 carboxamide groups, preferably formamidium or acetamidium groups. The hydrogen atoms in the organic cations, A, may be substituted by halogens selected from F, Cl, I and Br, preferably For Cl. Preferably, A is $Cs^+$ or methyl ammonium ion ($MA^+$), or formamidium ion ($FA^+$).

M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$; preferably $Pb^{2+}$, $Sn^{2+}$.

X is monovalent anion, independently selected from the group consisting of $Cl^-$, $Br^-$, $I^-$, $NCS^-$, $CN^-$, and $NCO^-$; preferably $Cl^-$, $Br^-$, or $I^-$. X may be the same or different.

According to the preferred embodiment, the examples of organic-inorganic perovskites are: methyl ammonium lead halides, for example, methylamonium lead iodide ($CH_3NH_3PbI_3$); methylamonium lead mixed halides, for example, $CH_3NH_3PbClI_2$; formamidium lead halides, for example, $HC(NH_2)_2PbI_3$, $HC(NH_2)_2PbBr_3$ or $HC(NH_2)_2PbCl_2I$; cesium lead iodide ($CsPbI_3$), cesium tin iodide ($CsSnI_3$).

In a further embodiment, the organic-inorganic perovskite layer material comprises a mixed perovskite-structure,

wherein A is the mixture of two or more cations as defined above, X is the mixture of two or more anions as defined above. Preferably, A is the mixture of two cations, M is Pb and X is a mixture of two anions. The formula (**II**) may be expressed as formula (**III**) below:

$$A^1_{1-y} A^2_y PbX^1_{3-z}X^2z \quad \text{(III)}$$

wherein:

$A^1$ and $A^2$ are organic monovalent cations as defined above for A;
$X^1$ and $X^2$ may be the same or different monovalent anions selected from the group consisting of $Cl^-$, $Br^-$, $I^-$, $NCS^-$, $CN^-$ and $NCO^-$;
y is in the interval between 0.1 and 0.9;
z is in the interval between 0.2 and 2.

The sensitizer layer is coated by a layer comprising a hole transporting layer (HTL), which may include an inorganic and/or organic hole transfer material. The inorganic hole transfer material may include at least one selected from nickel oxide ($NiO_x$), CuSCN, $CuCrO_2$, and CuI.

The organic hole transfer material may include carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives, aromatic tertiary amine compounds, styrylamine compounds, aromatic dimethylidine-based compounds, porphyrin-based compounds, phthalocyanine-based compounds, polythiophene derivatives, polypyrrole derivatives, polyparaphenylenevinylene derivatives, pentacene, coumarin 6,3-(2-benzothiazolyl)-7-(diethylamino)coumarin, ZnPC (zinc phthalocyanine), CuPC (copper phthalocyanine), TiOPC (titanium oxide phthalocyanine), Spiro-MeOTAD (2,2' ,7,7'-tetrakis(N,N-p-dimethoxyphenylamino)-9,9'-spirobifluorene), F16CuPC(copper(II) 1,2,3,4,8,9,10,11,15,16,17,18,22,23,24,25-hexadecafluoro-29H,31H-phthalocyanine), SubPc (boron subphthalocyanine chloride) and N3(cis-di(thiocyanato)-bis(2,2'-bipyridyl-4,4'-dicarboxylic acid)-ruthenium(II), P3HT (poly[3-hexylthiophene]), MDMO-PPV(poly[2-methoxy-5-(3' ,7'-dimethyloctyloxyl)]-1,4-phenylene vinylene), MEH-PPV(poly[2-methoxy-5-(2''-ethylhexyloxy)-p-phenylene vinylene]), P3OT (poly(3-octyl thiophene)), POT (poly(octylthiophene)), P3DT(poly(3-decylthiophene)), P3DDT (poly(3-dodecyl thiophene), PPV (poly(p-phenylene vinylene)), TFB(poly(9,9'-dioctylfluorene-co-N-(4-butylphenyl)diphenyl amine), polyaniline, Spiro-MeOTAD ([2,22',7,77'-tetrkis(N,N-di-pmethoxyphenyl amine)-9,9,9'-spirobi fluorine]), CuSCN, CuI, PCPDTBT(Poly [2,1,3-benzothiadiazole-4,7-diyl[4,4-bis(2-ethylhexyl-4H-cyclopen ta [2,1-b:3,4-b']dithiophene-2,6-diyl]], Si-PCPDTBT(poly[(4,4' -bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4' ,7-di-2-thieny 1-2',1',3'-benzothiadiazole)]), PFO-DBT(poly[2,7-.9,9-(dioctyl-fluorene)-alt-5,5-(4' ,7'-di-2-thienyl-2', 1',3'-benzothiadiazole)]), PSiFDTBT (poly[(2,7-dioctylsilafluorene)-2,7-diyl-alt-(4,7-bis(2-thienyl)-2,1, 3-benzothiadiazole)-5,5'-diyl]), PCDTBT (poly [[9-(1-octylnonyl)-9H-carbazole-2,7-diyl] -2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, and/or MeO-2PACz, 4-PACz.

Also provided herein are the methods of preparation of an electron transporting layer using the compound of present invention. Various methods can be used in order to form and produce the electron transporting layer comprising one or more compounds of the present invention. Suitable coating methods that provide a thin monolayer of the electron transporting layer may be selected from various hereby disclosed solution-based coating methods, for example, as provided below.

The spin-coating method for the formation of self-assembling monolayers on TCO substrates, for example, for the use in perovskite solar cells, may comprise the steps:

1) providing a substrate covered with an oxide layer (TCO); for example, providing a glass substrate covered with ITO (i.e. conducting support layer);
2) Optionally cleaning the substrate covered with an oxide layer by sonication; for example, sonication may take place in a sonication bath in acetone and/or isopropyl alcohol (IPA); for example, sonication may be performed for 15 min;
3) Optionally treating the substrate covered with TCO with UV ozone or plasma-treating; for example, treatment may be applied for 15 min;
4) Providing a solution comprising a solvent and a compound according to formula (I); for example, a solution of from 0.1 mg/ml to 10 mg/ml concentration of the compound of formula (I) dissolved in chlorobenzene may used, preferably about 1 mg/ml concentration may be used;
5) Spin-coating the compound according to figure (I) in a solution on the substrate; for example, by rotating at 5,000

r.p.m for 30 s;
6) Thermally annealing the compound to the substrate covered with TCO; for example, by heating at 100°C for the time period of 10 min to 60 min, preferably for 10 min;
7) Optionally, washing the resulting coated substrate; washing is performed to remove the unbound molecules, for example, washing is performed with the solvent by dynamic spin-coating at 5,000 r.p.m for 30 s.

In preferred embodiments, the spin-coating method for the formation of self-assembling monolayers on TCO substrates, comprises the step 3) treating the substrate covered with TCO with UV ozone or plasma-treating.
The immersing/dipping method for the formation of self-assembling monolayers on TCO substrates, for example, for the use in perovskite solar cells, may comprise the steps:

1) providing a substrate covered with an oxide layer (TCO); for example, providing a glass substrate covered with ITO (i.e. conducting support layer);
2) Optionally cleaning the substrate covered with an oxide layer by sonication; for example, sonication may take place in a sonication bath in acetone and/or isopropyl alcohol (IPA); for example, sonication may be performed for 15 min;
3) Optionally treating the substrate covered with TCO with UV ozone or plasma-treating; for example, treatment may applied for 15 min;
4) Providing a solution comprising a solvent and a compound according to formula (I); for example, a solution of from 0.1 mg/ml to 10 mg/ml concentration of the compound of formula (I) dissolved in chlorobenzene may used, preferably about 1 mg/ml concentration may be used;
5) Immersing the substrate covered with TCO in a solution comprising the compound according to formula (I); for example, immersing may be performed from 10 min to 24 hours, preferably for about 1 hour;
6) Thermally annealing the compound to the substrate covered with TCO; for example, by heating at 100°C for the time period of 10 min to 60 min, preferably for 10 min;
7) Optionally, washing the resulting coated substrate; washing is performed to remove the unbound molecules, for example, washing is performed with the solvent by dynamic spin-coating at 5,000 r.p.m for 30 s.

In preferred embodiments, the immersing/dipping method for the formation of self-assembling monolayers on TCO substrates, comprises the step 3) treating the substrate covered with TCO with UV ozone or plasma-treating.
Other solution-based coating methods may be suitable for the formation of self-assembling monolayers on TCO substrates, for example, spray-coating, slot-die coating, inject printing, doctor-blading, screen-printing etc. When used, such methods may comprise the same steps as the above provided spin-coating method, characterized in that instead of the spin-coating step, a spray-coating, slot-die coating, inject printing, doctor-blading, or screen-printing step is performed respectively, depending on the method used.
Once the formation of self-assembling monolayers (SAM) on TCO substrates is achieved by the methods as described above, further steps of thermal annealing (e.g. at 80°C for about 5 min) may be performed, in order to remove the solvent.
Alternatively, SAM may be formed on TCO substrate by thermal evaporation For example, evaporation may be performed in a thermal evaporation system, where the formed SAM films may be deposited at pressures of $\approx 5 \times 10^{-6}$ mbar, at rates of 0.15-0.25 $Ås^{-1}$, and can be done at rates rates up to 0.6 $Ås^{-1}$ [23]. Afterwards, the thermally annealing or evaporated films may be washed using 1 step spin-coating program (for example, 3,000 rpm for 40 s) and, for example, ethanol.
In some embodiments, the method of formation of self-assembling monolayers on TCO substrates, for example, for the use in perovskite solar cells, may comprise a step of simultaneous forming of SAM ETL comprising the compound of formula (I) and a perovskite layer. In such method, for example, a single treating step using a single solution containing both additives - compound of formula (I) and perovskite precursor may form a SAM layer and a perovskite layer. The method, for example, may comprise the steps:

1) preparing a solution comprising a perovskite precursor, a solvent, and a compound according to formula (I);
2) applying the solution to a substrate to form a liquid layer on the substrate; and
3) treating the liquid layer to form a perovskite layer positioned adjacent to a first layer comprising the molecule.

EXAMPLES

Information on examples of real embodiments is provided below, describing the modes of preparation of exemplary compounds (**V1612**, **V1625**, **V1486, V1624, V1635**) and properties thereof. This information is provided for illustrative purpose and is not limiting.

## Example 1

*General Synthesis Scheme of Compounds of General Formulae (I): Symmetric structures of electron transporting naphthalenediimide-based SAM compounds.*

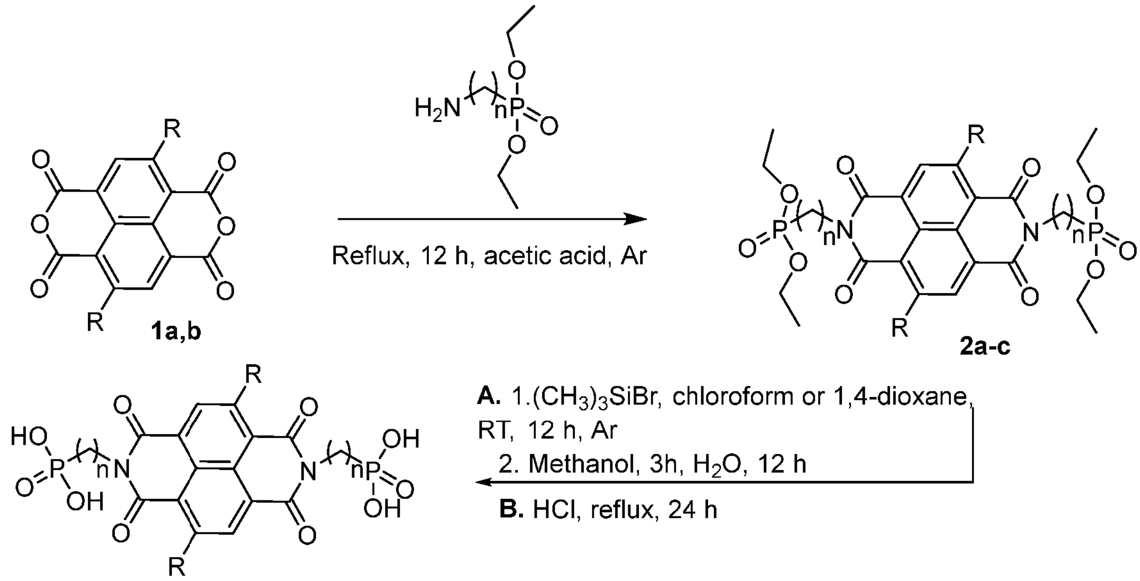


**1a,b**

**2a-c**

**V1612, V1625, V1486**

**1a, 2a,b, V1612, V1625 R = H; 2a, 2c, V1612, V1486 n = 1;**
**1b, 2c, V1486, R = Br; 2b, V1625 n= 2.**

**Scheme 1**. Synthesis route to the symmetric structure of electron transporting naphthalene-diimide-based SAM compounds **V1612**, **V1625**, and **V1486**.

Electron transporting naphthalenediimide-based compounds **V1612**, **V1625**, and **V1486** containing phosphonic acid anchoring groups and corresponding to the general formula (**I**) were prepared by the two-step synthesis route shown in Scheme 1.

The first step was the refluxing of commercially available 1,4,5,8-napthalenetetracarboxylic dianhydride (**1a**, TCI Europe) or 2,6-dibromo-naphthalene-1,4,5,8-tetracarboxylic dianhydride (**1b**, TCI Europe) with (aminomethyl)phosphonic acid (abcr GmbH) or(aminoethyl)phosphonic acid (abcr GmbH) in acetic acid to form the intermediates **2a-c**, possessing symmetric ether groups (Scheme 1). The next step was hydrolysis of the intermediates **2a-c** with bromotrimethylsilane at room temperature (method A) or at reflux of concentrated hydrochloric acid (method B). The target products were obtained as beige crystals.

*N, N'-bis[diethyl(methyl)]-1,4,5,8-naphthalene tetracarboxylic diimide diphosphonate (**2a**):*

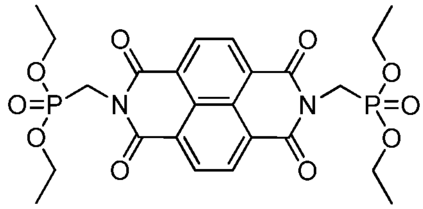

A mixture of 1,4,5,8-napthalenetetracarboxylic dianhydride (**1a**, 2 g, 7.45 mmol) and diethyl(aminomethyl)phosphonate (2.68 ml; 16.33 mmol) was refluxed in acetic acid (40 ml) for 12 hours under argon atmosphere. After the termination of the reaction (TLC: methanol:dichlormethane, 7:243), reaction mixture was extracted with EtOAc and organic layer was dried over anhydrous $Na_2SO_4$. The crude product was purified by column chromatography (methanol:dichlormethane, 5:245) to obtain as white crystals of **2a** (2.87 g, (68 %); m.p. 248-249 °C. $^1H$ NMR (400 MHz, $CDCl_3$) δ: 8.79 (s, 4H), 4.69 (d, *J* = 12.7 Hz, 4H), 4.32 - 4.07 (m, 8H), 1.34 (t, *J* = 7.0 Hz, 12H) ppm. $^{13}C$ NMR (101 MHz, $CDCl_3$) δ: 162.20, 131.48, 126.86, 126.65, 63.00, 62.94, 37.00, 35.46, 16.54, 16.48 ppm. Anal. calcd. for $C_{24}H_{28}N_2O_{10}P_2$: C 50.89; H 4.98; N 4.95; found: C 50.95; H 4.82; N 4.80.

*N, N'-bi(methyl)-1,4,5,8-naphthalene tetracarboxylic diimide diphosphonic acid (**V1612**)*

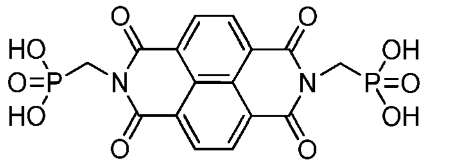

*Method A. N, N'*-bis[diethyl(methyl)]-1,4,5,8-naphthalene tetracarboxylic diimide (**2a**, 0.4 g, 0.70 mmol) was dissolved in chloroform (20 ml) followed by a dropwise addition of bromotrimethylsilane (1.35 ml, 14.1 mmol). The reaction mixture was stirred for 12 hours at 25 °C under argon atmosphere. After reaction completion (TLC: methanol:dichlormethane, 5:245), methanol (3 ml) was added and stirring continued for 3 hours. Then, distilled water (30 ml) was added dropwise until beige precipitate was formed and stirring continued for 12 hours. Precipitate was filtered off and washed with distilled water (20 ml) and THF (10 ml). Product obtained as beige crystals (0.2 g, 62 % yield).

*Method B. N, N'*-bis[diethyl(methyl)]-1,4,5,8-naphthalene tetracarboxylic diimide (**2a**, 2.87 g, 5.06 mmol) and concentrated hydrochloric acid (80 ml) were refluxed for 24 hours. Formed beige solid was filtered off and washed with 100 ml distilled water and THF (80 ml). Product obtained as beige crystals 2.22 g (96 % yield); m.p. >405 °C. Anal. calcd. for $C_{16}H_{12}N_2O_{10}P_2$: C 42.31; H 2.66; N 6.17; found: C 42.22; H 2.5; N 6.05. MS (ESI, pos. mode), *m/z*: 453 (M-1).

## Example 2

*N, N'-bis[diethyl(ethyl))-1,4,5,8-naphthalene tetracarboxylic diimide diphosphonate (**2b**)*

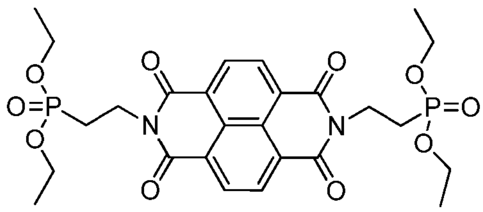

A mixture of 1,4,5,8-napthalenetetracarboxylic dianhydride (**1a**, 2 g, 7.46 mmol) and diethyl(2-aminoethyl) phosphonate (2.7 ml; 16.39 mmol) was refluxed in acetic acid (40 ml) for 48 hours under argon atmosphere. After the termination of the reaction (TLC: methanol:dichlormethane, 7:243), reaction mixture was extracted with EtOAc and organic layer was dried over anhydrous $Na_2SO_4$. The crude product was purified by column chromatography (methanol:dichlormethane, 7:243) to obtain as white yellowish crystals (1.9 g, (43 %); m.p. 226-227 °C. $^1H$ NMR (400 MHz, $CDCl_3$) δ: 8.75 (s, 4H), 4.49-4.26 (m, 4H), 4.22-4.05 (m, 8H), 2.37-2.05 (m, 4H), 1.34 (t, *J* = 7.0 Hz, 12H) ppm. $^{13}C$ NMR (101 MHz, $CDCl_3$) δ: 162.61, 131.22, 126.88, 126.70, 62.13, 62.07, 35.26, 25.19, 23.81, 16.60, 16.54 ppm. Anal. calcd. for $C_{26}H_{32}N_2O_{10}P_2$: C 52.53; H 5.43; N 4.71; found: C 52.30; H 5.32; N 4.50.

*N, N'-bis(ethyl)-1,4,5,8-naphthalene tetracarboxylic diimide diphosphonic acid (**V1625**)*

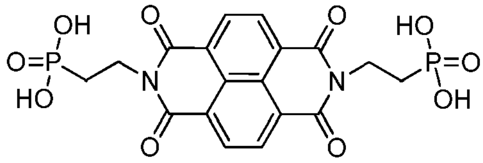

*N, N'*-bis[diethyl(ethyl)]-1,4,5,8-naphthalene tetracarboxylic diimide (**2b**, 1.8 g, 3.02 mmol) and concentrated hydrochloric acid (60 ml) were refluxed for 24 hours. Formed beige solid was filtered off and washed with 80 ml distilled water and THF (50 ml). Product obtained as beige crystals 1.36 g (93 % yield); m.p. >405 °C. Anal. calcd. for $C_{18}H_{16}N_2O_{10}P_2$: C 44.83; H 3.34; N 5.81; found: C 44.61; H 3.13; N 5.59. MS (ESI, pos. mode), *m/z*: 481 (M-1).

**Example 3**

*2,6-Dihromo-N,N'-[diethyl(methyl)]-1,4,5,8-naphthalenetetracarboxdiimide diphosphonate (2c)*

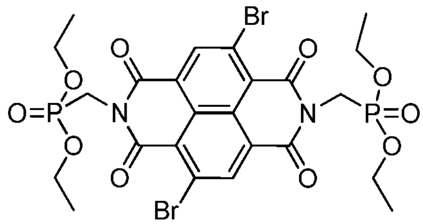

A mixture of 2,6-dibromonaphthalene-1,4,5,8-tetracarboxylic dianhydride (**1b**, 1 g, 1.16 mmol) and diethyl(aminomethyl)phosphonate (0.36 ml; 2.20 mmol) was refluxed in acetic acid (20 ml) for 4 hours under argon atmosphere. After the termination of the reaction (TLC: methanol:dichlormethane, 5:245), distilled water was poured (200 ml) into the mixture. The red precipitated solid was filtered off and washed with water (100 ml). The crude product was purified by column chromatography (methanol:dichlormethane, 5:245) to give as yellow crystals (0.522 g, (33 %); m.p. >405 °C. $^1$H NMR (400 MHz, $CDCl_3$) δ: 9.00 (s, 2H), 4.68 (d, *J* = 12.8 Hz, 4H), 4.33-4.08 (m, 8H), 1.35 (t, *J* = 7.0 Hz, 12H) ppm. $^{13}$C NMR (101 MHz, $CDCl_3$) δ: 160.27, 160.04, 139.45, 128.93, 127.86, 125.28, 124.28, 63.06, 63.00, 37.27, 35.73, 16.52, 16.46 ppm. Anal. calcd. for $C_{24}H_{26}Br_2N_2O_{10}P_2$: C 39.80; H 3.62; N 3.87; found: C 40.22; H 3.7; N 3.93.

*2,6-Dibromo-N,N'-bis(ethyl)-1,4,5,8-naphthalene tetracarboxylic diimide diphosphonic acid (**V1486**)*

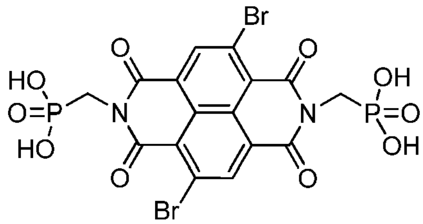

2,6-Dibromo-*N,N'*-[diethyl(methyl)]-1,4,5,8-naphthalenetetracarboxdiimide diphosphonate (**2c**)

(0.522 g, 0.72 mmol) was dissolved in anhydrous 1,4-dioxane (25 ml) followed by a dropwise addition of bromotrimethylsilane (1.9 ml, 12.41 mmol). The reaction mixture was stirred for 14 hours at 25 °C under argon atmosphere. After reaction completion (TLC: methanol:dichlormethane, 5:245), methanol (3.5 ml) was added and stirring continued for 4 hours. Then, distilled water (50 ml) was added dropwise until yellow precipitate was formed and stirring continued for 12 hours. Precipitate was filtered off and washed with distilled water (50 ml) and THF (20 ml). Product obtained as yellow crystals (0.336 g, 76 % yield). $^1$H NMR (400 MHz, DMSO-$d_6$) δ 8.76 (s, 2H), 4.40 (d, *J* = 12.7 Hz, 4H), 3.56 (s, 2H) ppm. $^{13}$C NMR (101 MHz, DMSO) δ: 159.99, 159.74, 137.38, 127.34, 126.78, 125.63, 124.17, 16.36 ppm. Anal. calcd. for $C_{16}H_{10}Br_2N_2O_{10}P_2$: C 31.40; H 1.65; N 4.58; found: C 31.21; H 1.50; N 4.4.

**Example 4**

*General Synthesis Scheme of Compounds of General Formulae (I): asymmetric structures of electron transporting naphthalenediimide-based SAM compounds.*

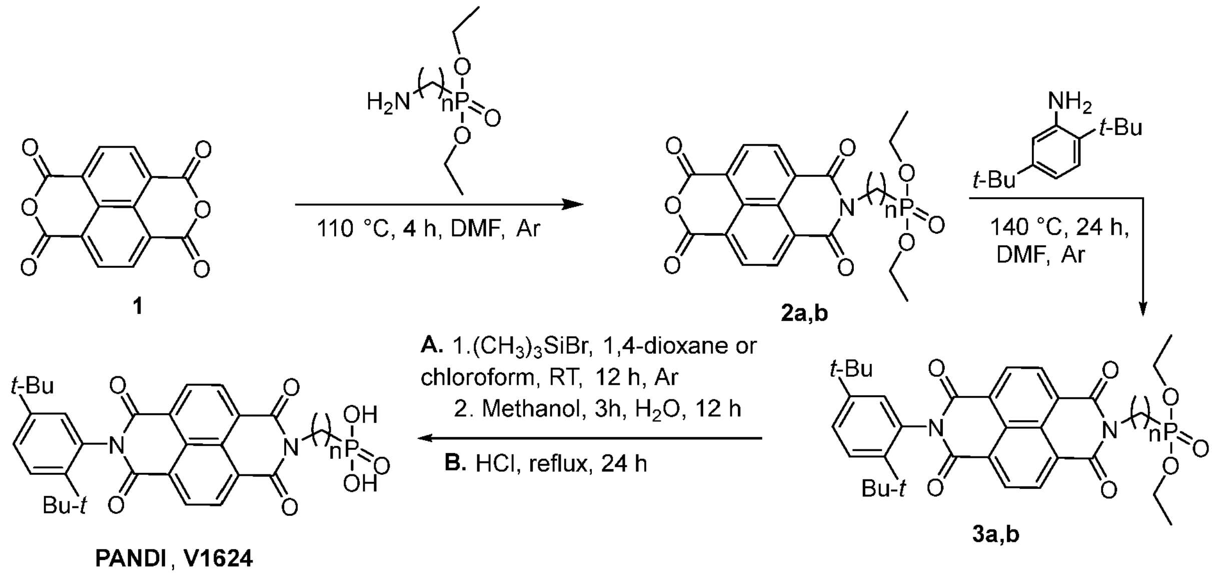


**2a, 3a, PANDI n = 1; 2b, 3b, V1624 n= 2.**

**Scheme 2**. Synthesis route to the unsymmetric structures of electron transporting naphthalene-diimide-based SAM compounds **V1264** and **V1624**.

Electron transporting naphthalenediimide-based compounds **V1264** and **V1624** containing phosphonic acid anchoring group and corresponding to the general formula (**I**) were prepared by the three-step synthesis route shown in Scheme 2. The first two steps were performed by one-pot operation: we first carried out the reaction of commercially available 1,4,5,8-napthalenetetracarboxylic dianhydride (1, TCI Europe) and diethyl(aminomethyl)phosphonate or diethyl(aminoethyl)phosphonate (abcr GmbH) in anhydrous DMF at 110 °C and then an imidization reaction of **2a**,**b** and 2,5-di-*tert*-butylaniline gives the intermediates **3a**,**b** (Scheme 2). The final step was hydrolysis of the phosphonates **3a**,**b** with bromotrimethylsilane at room temperature (method A) or at reflux of concentrated hydrochloric acid (method B). The target products were obtained as greenish yellow crystals.

*N-(2,5-di-tert-butyl-phenyl)-N'-[diethyl(methyl)]-1,4,5,8- naphthalene tetracarboxylic diimide phosphonate (**3a**)*

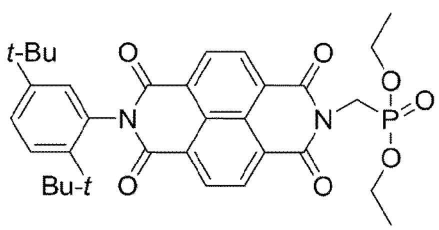

1,4,5,8-napthalenetetracarboxylic dianhydride (**1**, 0.5 g, 1.86 mmol) was dissolved in anhydrous DMF (50 ml) and diethyl(aminomethyl)phosphonate (0.337 g, 1.86 mmol) was added dropwise. The solution was stirred at 110 °C for 4 hours under argon atmosphere. Afterwards (TLC: acetone:*n*-hexane, 1:4, TLC was developed with 1 % ninhydrin solution) 2,5-di-*tert*-butylaniline (0.458 g, 2.23 mmol) was added, reaction mixture was heated up to 140 °C and reaction carried out for additional 24 hours. After the termination of the reaction (TLC: acetone:*n*-hexane, 1:4), reaction mixture was extracted

with ethyl acetate. The organic layer was dried over anhydrous $Na_2SO_4$ and the solvent was evaporated under reduced pressure. The crude product was purified by column chromatography (acetone:n-hexane, 1:4) yielding product as a greenish yellow powder (0.359 g, 32 %); m.p. 217-218 °C. $^1H$ NMR (400 MHz, $CDCl_3$) δ: 8.82 (s, 4H), 7.60 (d, *J* =8.6 Hz, 1H), 7.48 (d, *J* = 10.8 Hz, 1H), 7.00 (s, 1H), 4.71 (d, *J* =12.8 Hz, 2H), 4.30-4.19 (m, 4H), 1.36 (t, *J* = 7.1 Hz, 6H), 1.32 (s, 9H), 1.26 (s, 9H) ppm. $^{13}C$ NMR (101 MHz, $CDCl_3$) δ: 163.87, 162.33, 150.51, 143.82, 132.09, 131.56, 131.52, 129.13, 127.66, 127.07, 126.82, 126.60, 62.99, 62.93, 36.96, 35.69, 34.41, 31.84, 31.32, 16.55, 16.49 ppm. Anal. calcd. for $C_{33}H_{37}N_2O_7P$: C 65.55; H 6.17; N 4.63; found: C 65.29; H 5.91; N 4.34.

*N*-(2,5-di-*tert*-butyl-phenyl)-*N'*-(methyl)-1,4,5,8-naphthalene tetracarboxylic diimide phosphonic acid (**V1264**)

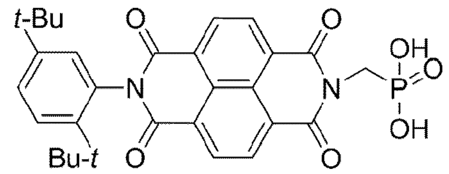

*Method I.* *N*-(2,5-di-*tert*-butyl-phenyl)-*N'*-[diethyl(methyl)]-1,4,5,8-naphthalene tetracarboxylic diimide phosphonate (**3a**) (0.150 g, 0.24 mmol) was dissolved in anhydrous 1,4-dioxane (5 ml) followed by a dropwise addition of bromotrimethylsilane (0.32 ml, 2.42 mmol). The reaction mixture was stirred for 12 hours at 25 °C under argon atmosphere. After reaction completion (TLC: acetone:*n*-hexane, 1:4), methanol (1 ml) was added and stirring continued for 4 hours. Then, distilled water (10 ml) was added dropwise until yellow precipitate was formed and stirring continued for 12 hours. Precipitate was filtered off and washed with diethyl ether (150 ml). Product obtained as greenish yellow crystals (0.096 g, 73 % yield).

*Method II.* *N*-(2,5-di-*ter*t-butyl-phenyl)-*N'*-[diethyl(methyl)]-1,4,5,8-naphthalene tetracarboxylic diimide phosphonate (**3a**) (0.200 g, 0.36 mmol) and concentrated hydrochloric acid (25 ml) were refluxed for 24 hours. Formed yellow solid was filtered off and washed with 200 ml distilled water. The product dissolved in THF (50 ml) and recrystallized from diethyl ether (250 ml). The crystals were filtered off and washed with diethyl ether (50 ml) to obtain of yellow crystals 0.173 g (95 % yield); m.p. 275-276 °C. $^1H$ NMR (400 MHz, $CDCl_3$) δ: 8.78 (s, 4H), 7.57 (d, *J* =8.6 Hz, 1H), 7.46 (d, *J* =10.6 Hz, 1H), 6.99 (s, 1H), 4.53 (s, 2H), 3.49 (s, 1H), 3.48 (s, 1H), 1.26 (s, 9H), 1,22 (s, 9H) ppm. $^{13}C$ NMR (101 MHz, $CDCl_3$) δ: 163.95, 162.73, 150.46, 143.79, 132.13, 131.91, 131.53, 129.11, 127.64, 127.50, 126.80, 126.37, 66.01, 34.38, 31.85, 31.30, 29.84 ppm. Anal. calcd. for $C_{29}H_{29}F_5N_2O_7P$: C 63.50; H 5.33; N 5.11; found: C 63.27; H 5.08; N 4.88. MS (ESI, pos. mode), *m/z*: 547 ($M+H^+$).

## Example 5

*N-(2,5-di-tert-butyl-phenyl)-N'-[diethyl(ethyl)]-1,4,5,8- naphthalene tetracarboxylic diimide phosphonate (**3b**)*

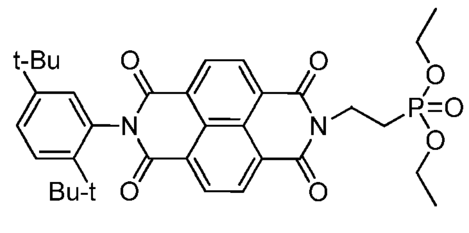

1,4,5,8-napthalenetetracarboxylic dianhydride (**1**, 0.5 g, 1.86 mmol) was dissolved in anhydrous DMF (40 ml) and diethyl(2-aminoethyl)phosphonate (0.3 ml, 1.86 mmol) was added dropwise. The solution was stirred at 110 °C for 4 hours under argon atmosphere. Afterwards (TLC: acetone:*n*-hexane, 8:17) 2,5-di-*tert*-butylaniline (0.458 g, 2.23 mmol) was added, reaction mixture was heated up to 140 °C and reaction carried out for additional 24 hours. After the termination of the reaction (TLC: acetone:n-hexane, 8:17), reaction mixture was extracted with ethyl acetate. The organic layer was dried over anhydrous $Na_2SO_4$ and the solvent was evaporated under reduced pressure. The crude product was purified by column chromatography (acetone:*n*-hexane, 8:17) yielding product as a beige powder (0.35 g, 30 %); m.p. 234-235 °C. $^1H$ NMR (400 MHz, $CDCl_3$) δ: 8.81 (s, 4H), 7.59 (d, *J* = 8.6 Hz, 1H), 7.48 (d, *J* = 8.5 Hz, 1H), 6.99 (s, 1H), 4.57-4.42 (m, 2H), 4.27-4.06 (m, 4H), 2.36-2.22 (m, 2H), 1.37 (t, *J* = 7.0 Hz, 6H), 1.32 (s, 9H), 1.25 (s, 9H) ppm. $^{13}C$ NMR (101 MHz, $CDCl_3$) δ:

163.91, 162.72, 150.48, 143.80, 131.54, 131.30, 129.12, 127.64, 127.30, 127.18, 127.11, 126.82, 68.10, 62.16, 35.67, 35.24, 34.40, 31.84, 31.32, 25.74, 16.61, 16.55 ppm. Anal. calcd. for $C_{34}H_{39}N_2O_7P$: C 66.01; H 6.35; N 4.53; found: C 65.91; H 6.26; N 4.55.

*N-(2,5-di-tert-butyl phenyl)-N'-(ethyl)-1,4,5,8-naphthalene tetracarboxylic diimide phosphonic acid (**V1624**)*

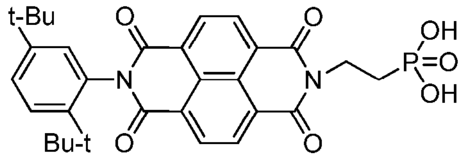

*N*-(2,5-di-*tert*-butyl-phenyl)-*N'*-[diethyl(ethyl)]-1,4,5,8-naphthalene tetracarboxylic diimide phosphonate (**3b**) (0.22 g, 0.35 mmol) and concentrated hydrochloric acid (15 ml) were refluxed for 24 hours. After reaction completion (acetone:*n*-hexane, 8:17), solvent was evaporated and crude product dissolved in THF (60 ml) and recrystallized into diethyl ether (280 ml). The crystals were filtered off and washed with diethyl ether (40 ml) to give of yellow crystals (0.19 g, 95 % yield); m.p. 213-214 °C. $^1H$ NMR (400 MHz, DMSO-$d_6$) $\delta$: 8.71 (s, 4H), 7.56 (d, *J* = 8.5 Hz, 1H), 7.45 (d, *J* = 8.5 Hz, 1H), 7.37 (s, 1H), 4.28 (s, 2H), 2.53 (s, 1H), 2.18 (s, 1H), 2.08-1.90 (m, 2H), 1.27 (s, 9H), 1.16 (s, 9H) ppm. $^{13}C$ NMR (101 MHz, DMSO-$d_6$) $\delta$: 163.84, 162.46, 143.22, 139.21, 132.92, 130.70, 130.45, 128.27, 128.05, 126.89, 126.63, 126.44, 35.07, 34.40, 34.05, 31.34, 31.04, 30.43 ppm. Anal. calcd. for $C_{30}H_{31}N_2O_7P$: C 64.05; H 5.55; N 4.98; found: C 64.20; H 5.39; N 4.81.

**Example 6**

*N-(2,5-di-tert-butyl-phenyl)-N'-(phenyl)-1,4,5,8- naphthalene tetracarboxylic diimide phosphonate*

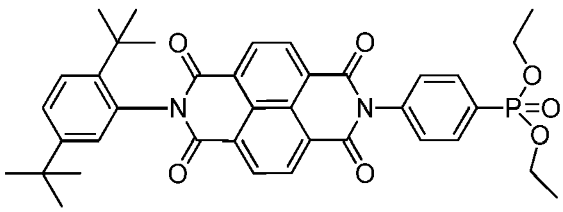

1,4,5,8-Napthalenetetracarboxylic dianhydride (**1**, 0.5 g, 1.86 mmol) was dissolved in anhydrous DMF (40 ml) and diethyl(4-aminophenyl)phosphonate (0.427 g, 1.86 mmol) was added. The solution was stirred at 140 °C for 12 hours under argon atmosphere. Afterwards (TLC: acetone:*n*-hexane, 12:13) 2,5-di-*tert*-butylaniline (0.459 g, 2.23 mmol) ) was added, reaction mixture was heated up to reflux and reaction carried out for additional 12 hours. After the termination of the reaction (TLC: acetone:*n*-hexane, 9:16), reaction mixture was extracted with ethyl acetate. The organic layer was dried over anhydrous $Na_2SO_4$ and the solvent was evaporated under reduced pressure. The crude product was purified by column chromatography (acetone:*n*-hexane, 9:16) yielding product as beige crystals (0.131 g, 11 %); m.p. 165-166 °C. $^1H$ NMR (400 MHz, $CDCl_3$) $\delta$: 8.87 (s, 4H), 8.11-7.93 (m, 2H), 7.61 (d, *J* = 8.5 Hz, 1H), 7.48 (dd, *J* = 14.2, 8.2 Hz, 3H), 7.02 (s, 1H), 4.28-4.09 (m, 4H), 1.38 (t, *J* = 7.0 Hz, 6H), 1.33 (s, 9H), 1.28 (s, 9H) ppm. $^{13}C$ NMR (101 MHz, $CDCl_3$) $\delta$: 166.95, 163.85, 162.92, 150.56, 143.79, 138.39, 133.31, 133.20, 132.04, 131.74, 131.65, 130.80, 129.18, 129.07, 128.92, 127.63, 127.53, 127.47, 126.86, 62.58, 62.53, 35.71, 34.43, 31.87, 31.33, 30.45, 16.56, 16.49 ppm. Anal. calcd. for $C_{38}H_{39}N_2O_7P$: C 68.46; H 5.90; N 4.20; found: C 68.55; H 5.73; N 4.33.

*N-(2,5-di-tert-butyl-phenyl)-N'-(phenyl)-1,4,5,8-naphthalene tetracarboxylic diimide phosphonic acid (**V1635**)*

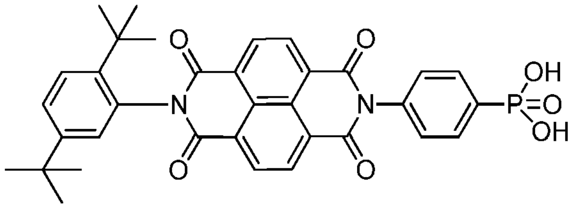

*N*-(2,5-di-*tert*-butyl-phenyl)-*N'*-(phenyl)-1,4,5,8- naphthalene tetracarboxylic diimide phosphonate (0.1 g, 0.14 mmol) and concentrated hydrochloric acid (15 ml) were refluxed for 24 hours. Formed yellow solid was filtered off and washed with 50 ml distilled water and diethyl ether (30 ml) to obtain of yellow crystals 0.081 g (89 % yield); m.p. 300-301 °C. $^{1}H$ NMR (400 MHz, $CDCl_3$) δ: 8.91-8.40 (m, 4H), 8.00 (s, 3H), 7.52 (t, *J* = 11.1 Hz, 1H), 7.42 (d, *J* = 8.4 Hz, 2H), 7.04 (s, 1H), 1.21 (s, 18H) ppm. $^{13}C$ NMR (101 MHz, $CDCl_3$) δ: 163.77, 163.09, 150.46, 143.64, 132.03, 131.47, 127.35, 126.81, 35.64, 34.35, 31.88, 31.25 ppm. Anal. calcd. for $C_{34}H_{31}N_2O_7P$: C 66.88; H 5.12; N 4.59; found: C 66.65; H 4.96; N 4.37.

**Example 7**

*Absorption spectra*

In the n-i-p structure PSC light first passes through the ETL, thus it is important to minimize parasitic absorption of this layer. Optical properties of electron transporting SAM compound **V1264** were investigated by means of UV/vis spectroscopy from $10^{-4}$ M anhydrous dichloromethane (FIG. 2a). Obviously, there is no apparent absorption in the visible region. Furthermore, UV-Vis transmittance results of electron transporting material SAM functionalization on the ITO surface show neglectable optical losses compared to the bare ITO and ITO/$SnO_2$ films (FIG.2b,c).

**Example 8**

*Thermogravimetric Analysis (TGA)*

TGA was performed on a Q50 thermogravimetric analyzer (TA Instruments) at a scan rate of 10 K $min^{-1}$ in the nitrogen atmosphere. As can be seen from FIG.3, the electron transporting SAM compound **V1264** has a 95 %weight loss temperature of 356 °C, which is suitable for the practical applications in optoelectronic devices.

**Example 9**

*Cyclic Voltammetry (CV)*

CV measurements were carried out by a three-electrode assembly cell from Bio-Logic SP-150. The measurements were carried out at a glassy carbon electrode in DMF and DCM solutions containing 0.1 M tetrabutylammonium hexafluorophosphate as an electrolyte, Pt as the counter electrode and as the reference electrode. Each measurement was calibrated with ferrocene (Fc) and potentials calculated to $Fc^+$/Fc. Conversion factors: ferrocene in DCM *vs* SCE 0.46, DMF *vs* SCE 0.45, SCE *vs* SHE: 0.244, SHE *vs* vacuum: 4.43 (N. G. Connelly, W. E. Geiger, Chemical Reviews 1996, 96, 877; V. V. Pavlishchuk, A. W. Addison, Inorganica Chimica Acta 2000, 298, 97). The half-wave potential $E_{1/2 vs Fc}$ was obtained as an average value between maxima of cathodic and anodic potentials: $E_{1/2\ vs\ Fc} = 1/2(E_{red} - E_{ox})$. The optical band gaps $E_{g\ opt.} = \frac{1240}{\lambda}$ was estimated from the edges of electronic absorption spectra in DCM and DMF solutions. $E_{LUMO}$ was calculated from the equation $E_{LUMO}$ = (E *vs* Fc/$Fc^+$ + (solvent *vs* SCE) + 0.244 + 4.43. $E_{HOMO}$ calculated from the equation $E_{HOMO} = E_{LUMO} + E_{g\ opt}$.

The voltammograms of **V1264** in solution show reversible reduction waves during the scans and are typical for NDI derivatives (FIG.4). The reversible process indicates that material exhibit good electrochemical stability. The calculated energy level redox potential measurements show the $E_{LUMO}$ levels of **V1264** are measured to be -3.81 eV, while $E_{HOMO}$ = -6.97 eV (Table 1). $E_{LUMO}$ of electron transporting compound demonstrate good alignment with the conduction band maxima of the perovskite absorbers, while $E_{HOMO}$ energy levels are sufficiently high to block holes from the perovskite layer.

**Table 3.** Energy level for electron transporting SAM compounds.

| Compound | E *vs* Fc/Fc⁺, [V] | $E_{HOMO}$, [eV] | $E_{LUMO}$, [eV] | λ, [nm] | $E_g^{opt-sol}$ , [eV] |
|---|---|---|---|---|---|
| **V1264** | -1.34 | -6.97 | -3.81 | 392 | 3.16 |
| **V1612** | -1.17 | -6.97 | -3.9 | 403 | 3.07 |
| **V1624** | -1.16 | -7.11 | -3.96 | 393 | 3.15 |
| **V1625** | -1.32 | -6.91 | -3.79 | 397 | 3.12 |
| **V1635** | -1.28 | -6,98 | -3.84 | 394 | 3.14 |
| **V1486** | -1.26 | -6.76 | -3.86 | 426 | 2.90 |

**Example 10**

*Characterization of ITO/NDI-SAM surface: contact angle measurements, SEM images*

The coated electron transporting molecules **V1264** onto ITO significantly increase ITO substrate's surface hydrophobicity to around 78.4° versus bare-ITO around 28.5° (FIG.5). It is noted that all the samples were washed with respective solvents to remove unbounded SAM molecules from the ITO substrate. This reveals that only attached SAMs onto ITO will affect the surface hydrophobicity that can be directly associated with our SAMs' coverage on ITO.[20] The higher hydrophobicity of ITO/SAM substrate will affect the crystallization and morphology of perovskite film.[21,22] The more hydrophobic surface (less wetting) of ITO/NDI-SAM surface can suppress the dragging force of perovskite inks, resulting in larger grain-size perovskite crystals, as indicated from top-view scanning electron microscopy (SEM) images in FIG.6a,b.[21,22] In addition, the *tert*butyl groups of **V1264** on the upper side can interact well with the perovskite layer, resulting in less pinholes or voids formed at ITO/ **V1264**/perovskite interface, see FIG.7.

The surface mapping of contact potential difference (CPD) values of V1264 on ITO confirmed uniformity of SAM coverage. The rather homogenous pattern was proportional to the narrow work function (WF) fluctuation in a specific area (~4.45 eV), overall indicating a good V1264 coverage on ITO.

**Example 11**

*Photovoltaic Cell Manufacture and Performance Measurements*

The performance of electron transporting self-assembling monolayer compound **V1264** was tested in mixed perovskite-based solar cells using a ITO photo-anode and an Ag cathode (ITO/ **V1264**/mixed perovskite/HTL/MoOx/Ag) (FIG. 8).

*Device fabrication:* patterned ITO/glass substrates were cleaned by a sonication bath in acetone and isopropyl alcohol (IPA) for 15 min, respectively, and followed treatment using UV-Ozone for 15 min for surface cleaning and increased oxygen concentration. Then, 0.5-1.0 mg/mL of **V1264** was dissolved in chlorobenzene. The SAM solution was coated on the ITO/glass via spin-coating at 5,000 r.p.m for 30 s followed by thermal annealing at 100°C for 10 min. After cooling down, the SAM's film was washed with chlorobenzene to remove unbounded molecules by dynamic spin-coating at 5,000 r.p.m for 30 s. Subsequently, thermal annealing at 80°C for 5 min was done to evaporate the remaining solvent. The 1.55 eV bandgap of perovskite solution (1.5 M) composed of triple A-site cation mixture was diluted in DMF: DMSO (4:1 v/v ratio) based on formula $Cs_{0.03}(FA_{0.90}MA_{0.10})_{0.97}PbI_3$ (S.-K. Jung, J. H. Heo, D. W. Lee, S.-C. Lee, S.-H. Lee, W. Yoon, H. Yun, S. H. Im, J. H. Kim, O.-P. Kwon, Advanced Functional Materials 2018, 28, 1800346). Thus, the perovskite solution was applied above the SAMs film via 2-step spin-coating with 2,000 r.p.m for 40 s and 6,000 r.p.m for 10 s to form the perovskite film. Solvent quenching using Anisole (300μl) as a standard procedure was applied at the last 10 s during spinning substrate, followed by annealing at 100°C for 40 min. After cooling down the HTL was coated on top of perovskite films at 4000 r.p.m for 35 s without additional annealing. The organic HTL was prepared by dissolving 72.3 mg of Spiro-OMeTAD, 28.8 μl *t*BP, and 17.5 μl LiTFSI in 1 mL of chlorobenzene. Then, 5 nm of $MoO_x$ and 100 nm of Ag were thermally evaporated under $10^{-6}$ Torr vacuum with metal mask area around 0.1 $cm^2$ to define the active area of devices.

n-i-p PSCs with pristine $SnO_2$ were used for comparison. The $SnO_2$ was prepared as follows: patterned ITO/glass substrates were cleaned by a sonication bath in acetone and isopropyl alcohol (IPA) for 15 min, respectively, and followed treatment using UV-Ozone for 15 min for surface cleaning and increased oxygen concentration. Then, the $SnO_2$ layer was prepared by spin-coating a colloidal dispersion (15 % in $H_2O$, Alfa Aesar) diluted with deionized water (1:4 v/v ratio) on the ITO substrates (4000 rpm 35seconds) followed by annealing at 150 °C for 25 minutes.

*Devices characterizations:* The fabricated perovskite photovoltaic cells were evaluated by photocurrent density-voltage (*J-V*) characteristics. *J-V* characteristic devices performance were measured in a steady $N_2$-purging glovebox under Abet Technologies Sun 3000 Solar Simulator equipped with a Keithley 2400 Source unit. The light source was calibrated to AM 1.5 G (100 mW $cm^2$) using a mono-silicon standard cell (Newport). Forward and Reverse scans were applied to all devices with 100 mV $s^{-1}$ scan rates with light soaking treatment 30 s before each measurement. The external quantum efficiency (EQE) spectra were organized on the optical breadboard equipped with 400 W Xenon lamp through a monochromator and filter inside the $N_2$ glove box and calibrated to 603621 Silicon and Germanium Reference Detector. Capacitance-voltage measurements were performed to obtain the capacitance with a sweeping frequency from 1 MHz to 1 Hz (10 mV AC voltage). The voltage varied from 0 to 1.2 V with constant frequency at 1 kHz.

The ETM self-assembling monolayer compound **V1264** exhibits a higher device performance with a maximum PCE of 21.5% ($V_{OC}$ of 1.13 V, $J_{SC}$ of 24.7 mA $cm^{-2}$, FF of 77%) under reverse scan with a negligible hysteresis (FIG.9). The external quantum efficiency (EQE) of **V1264**-based device exhibits a slightly higher overall Jsc than $SnO_2$-based device because of higher absorption in the EQE edge due to the lower optical reflectance losses of ITO/**V1264** film. The statistical distribution of electron-selective SAMs from 25 devices is shown in (FIG.11), which shows the reproducibility of **V1264-**based devices with narrower PCE distribution. This result represents the higher performance of electron-selective SAMs and ETL-free based on reported n-i-p PSCs, (FIG. 12).

**Example 12**

*Long-term stability tests of photovoltaic cells*

First, the devices based on $SnO_2$-ETL and SAM molecule **V1264** were stored inside $N_2$-glovebox at room temperature for 1000 hours and the devices were measured occasionally (FIG. 13a). The $SnO_2$-based *n-i-p* devices can only retain around 58% of their initial PCEs after 1000 hours of storage, while **V1264**-based devices showed a longer lifetime of around 84% retention.

Next, the thermal stability of photovoltaic devices we also evaluated at 65 °C under $N_2$-glovebox on the hot plate in dark conditions for more than 1000 hours and SAM molecule **V1264**-based and $SnO_2$-based devices were compared in FIG.13b. It clearly showed that SAM molecule **V1264**-based devices demonstrated better thermal stability, with around 72% retention of their initial PCEs, compared to $SnO_2$-based devices with only 38% retention under identical conditions.

It should be noted that the degradation of *n-i-p* devices can also be initiated due to doped-spiro-OMeTAD HTL under elevated temperature.[7,12] For this reason, SAM molecule **V1264**-based devices we also were evaluated employing relatively thermally stable HTL, using poly[bis(4-phenyl)(2,4,6-trimethylphenyl)amine] (PTAA) and showed above 90% retention under identical conditions.

**Example 13**

**Table 4. Solubility of various compounds**

| | Solubility in organic solvents | | | | | | |
|---|---|---|---|---|---|---|---|
| | Methanol | Isopropanol | THF | DCM | $CHCl_3$ | Chlorobenzene | Toluene |
| **V1264** | - | - | Up to 6.5 mg/ ml | Up to 15 mg/ ml | Up to 7.5 mg/ ml | Up to 13 mg/ ml | Up to 0.8 mg/ml |
| **V1486** | Up to 0.7 mg/ml (sonicated) | Up to 0.5 mg/ml (sonicated) | Up to 0.5 mg/ml (sonicated) | - | - | - | - |
| **V1612** | Up to 0.5 mg/ml (sonicated) | - | - | - | - | - | - |
| **V1624** | - | - | Up to 1 mg/ml | Up to 7 mg/ml | Up to 5 mg/ml | - | - |
| **V 1625** | Up to 0.5 mg/ml (sonicated) | - | - | - | - | - | - |

(continued)

| | Solubility in organic solvents | | | | | | |
|---|---|---|---|---|---|---|---|
| | Methanol | Isopropanol | THF | DCM | $CHCl_3$ | Chlorobenzene | Toluene |
| **V1635** | - | - | - | Up to 10 mg/ml | Up to 15 mg/ml | - | - |

**Example 14**

Further aspects of the disclosure are exemplified by the following numbered clauses:

Clause 1. A compound of formula (I), (IV) or (V)

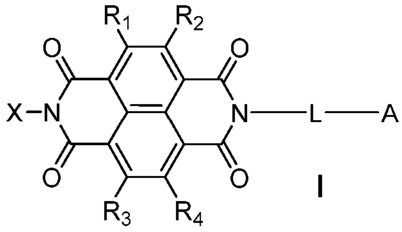

I

,

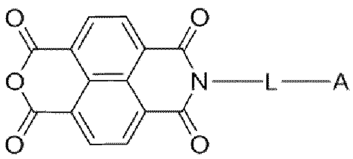

(IV),

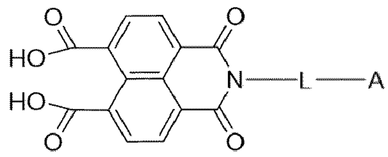

(V),

wherein

X is selected from $-L_1-A_1$, H, $NH_2$, $C_1-C_{10}$ alkyl, C2-C10 alkenyl, C2-C10 alkynyl, C4-C10 aryl, C4-C20 alkylaryl, C4-C20 alkenylaryl, and C4-C20 alkynylaryl, each of which is optionally substituted with C1-C10 alkyl, C2-C10 alkenyl, C2-C10 alkynyl, C1-C10 heteroalkyl, C4-C10 aryl, C2-C10 heteroalkenyl, C2-C10 heteroalkynyl, C4-C10 heteroaryl, or one or more heteroatoms selected from N, S and O;

$R_1$, $R_2$, $R_3$, $R_4$ is independently selected from H, CN, Cl, Br, F, $CF_3$, $NO_2$, C1-C20-alkyl, C2-20-perfluoroalkyl, C5-20-aryl, C5-20-heteroaryl;

A, $A_1$, $A_2$ is independently selected from phosphonic acid, monoalkyl ether of phosphonic acid, phosphoric acid, monoalkyl ether of phosphoric acid:

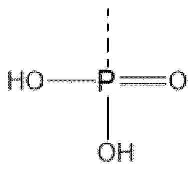
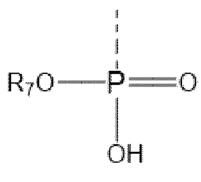
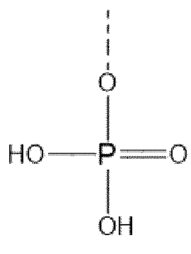
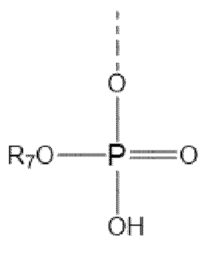

or a structure:

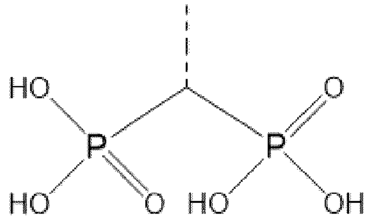

,

$R_7$ is C1-C9 alkyl group;

L, $L_1$ is independently selected from C1-C9 -alkylene, C4-C20 arylene, C4-C20 heteroarylene, C4-C20 alkylarylene, C4-C20 alkenarylene, C4-C20 heteroalkylarylene, C4-C20 heteroalkenarylene, wherein heteroatoms are selected from O, N, S, Se, Si, or from structure:

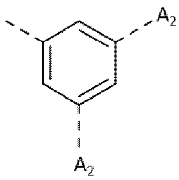

.

Clause 2. The compound according to clause 1, wherein the compound is according to formula (I).

Clause 3. The compound according to clause 1 or 2, wherein when each of $R_1$, $R_2$, $R_3$, $R_4$ is H, and each of A, $A_1$ is phosphonic acid, then L, $L_1$ is independently selected from C3-C9 -alkylene, C4-C20 arylene, C4-C20 heteroarylene, C4-C20 alkylarylene, C4-C20 heteroalkylarylene, C4-C20 heteroalkenarylene, wherein heteroatoms are selected from O, N, S, Se, Si, or from structure:

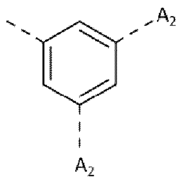

.

Clause 4. The compound according to any one of the preceding clauses, wherein A, $A_1$, and $A_2$ is phosphonic acid.

Clause 5. The compound according to any one of the preceding clauses, wherein L and $L_1$ are the same.

Clause 6. The compound according to any one of the preceding clauses, wherein X is $-L_1-A_1$.

Clause 7. The compound according to any one of clauses 1 to 4, wherein X is selected from H, $NH_2$, C1-C10 alkyl, C2-C10 alkenyl, C2-C10 alkynyl, C4-C10 aryl, C4-C20 alkylaryl, C4-C20 alkenylaryl, and C4-C20 alkynylaryl, each of which is optionally substituted with C1-C10 alkyl, C2-C10 alkenyl, C2-C10 alkynyl, C1-C10 heteroalkyl, C4-C10 aryl, C2-C10 heteroalkenyl, C2-C10 heteroalkynyl, C4-C10 heteroaryl, or one or more heteroatoms selected from N, S and O.

Clause 8. The compound according to clause 7, wherein X is selected from C4-C20 alkylaryl optionally substituted with C1-C10 alkyl.

Clause 9. A composition comprising one or more compounds according to any one of the preceding clauses.

Clause 10. The composition according to clause 9, further comprising a filler molecule (FM), wherein FM is at least one kind of molecule consisting of an anchoring group, an alkyl chain of N carbon atoms, with N is in the range of 1 to 18, and a functional group of at least one of the group methyl, halogen, amino, bromide, ammonium and sulfuric functional group.

Clause 11. An optoelectronic and/or photoelectrochemical device comprising an electron transporting layer comprising the compound according to any one of clauses 1 to 8 or the composition according to clause 9 or 10.

Clause 12. The optoelectronic and/or photoelectrochemical device according to clause 11, wherein the device is selected from a photovoltaic device, an organic photovoltaic device, a photovoltaic solid state device, an organic solar cell, a solid state solar cell, a perovskite solar cell, a tandem solar cell, a light emitting electrochemical cells, and OLED.

Clause 13. The optoelectronic and/or photoelectrochemical device according to clause 12, wherein the device is a photovoltaic device.

Clause 14. The photovoltaic device according to clause 13, comprising a conducting support layer covered with

electron transporting layer, a sensitizer layer, a hole transporting layer, and a counter electrode, wherein the electron transporting layer comprises the compound according to any one of clause 1 to 8 or the composition according to clause 9 or 10.

Clause 15. The photovoltaic device according to clause 14, wherein the electron transporting layer consists of the compound according to any one of clauses 1 to 8 or the composition according to clause 9 or 10.

Clause 16. The photovoltaic device according to any one of the clauses 12 to 15, wherein the device is a tandem solar cell, preferably wherein the tandem solar cell comprises at least one perovskite solar cell.

Clause 17. The photovoltaic device according to any one of clause 14 to 16, wherein the sensitizer layer comprises an organic-inorganic perovskite.

Clause 18. The photovoltaic device according to clause 17, wherein the organic-inorganic perovskite is a perovskite-type structure of formula (II):

$$AMX_3 \qquad (\mathbf{II})$$

wherein:

A is an alkali metal ion, preferably $Li^+$, $Na^+$, $K^+$, $Rb^+$, $Cs^+$; ammonium or amidinium ion, wherein one or more hydrogens are substituted by alkyl or acyl group;
M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;
X is monovalent anion, independently selected from the group consisting of $Cl^-$, $Br^-$, $I^-$, $NCS^-$, $CN^-$ , and $NCO^-$;

Clause 19. The photovoltaic device according to clause 18, wherein the organic-inorganic perovskite is a mixed perovskite-type structure according to formula (III):

$$A^1_{1-y} A^2_y PbX^1_{3-z}X^2_z \qquad (\mathbf{III})$$

wherein:

$A^1$ and $A^2$ are organic monovalent cations independently chosen from Li+, Na+, K+, Rb+, Cs+, ammonium, or amidinium ion; wherein one or more hydrogens of said ammonium or amidinium ions are substituted by alkyl or acyl groups or halogens;

$X^1$ and $X^2$ are the same or different monovalent anions selected from Cl-, Br-, I-, NCS-, CN-and NCO-;

y is in the interval between 0.1 and 0.9; and

z is in the interval between 0.2 and 2.

Clause 20. The photovoltaic device according to any one of clauses 14 to 19, wherein the conducting support layer comprises a conducting material selected from indium-doped tin oxide (ITO), indium zinc oxide (IZO), fluorine doped tin oxide (FTO), a metal, and/or other conductors.

The research work on this project was financially supported by the Horizon Europe Research and Innovation Action programme under Grant Agreement No. 101082176 of the VALHALLA project.

REFERENCES

[1] Best Research-cell Efficiencies Chart, https://www.nrel.gov/pv/assets/pdfs/best-research-cell-efficiencies.pdf

[2] L. Chao, T. Niu, W. Gao, C. Ran, L. Song, Y. Chen, W. Huang, Adv. Mater. 2021, 33, 2005410.

[3] F. Fu, J. Li, T. C. Yang, H. Liang, A. Faes, Q. Jeangros, C. Ballif, Y. Hou, Adv. Mater. 2022, 34, 2106540.

[4] J.Y. Kim, J.W. Lee, H.S. Jung, H. Shin, N.G. Park, Chem Rev, 2020, 120:7867-7918.

[5] H. Min, M. Kim, S.-U. Lee, H. Kim, G. Kim, K. Choi, J. H. Lee, S. I. Seok, Science 2019, 366, 749.

[6] H. Si, X. Zhao, Z. Zhang, Q. Liao,Y. Zhang, Coordination Chemistry Reviews 2024, 500: 215502.

[7] Y. Yao, C. Cheng, C. Zhang, H. Hu, K. Wang, S. De Wolf, Adv.Mater.2022, 34, 2203794.

[8] C. E. Puerto Galvis, D. A. Gonzalez Ruiz, E. Martinez-Ferrero, E. Palomares, Chem. Sci. 2023, DOI: 10.1039/d3sc04668k

[9] A. Al-Ashouri, A. Magomedov, M. Ross, M. Jost, M. Talaikis, G. Chistiakova, T. Bertram, J. A. Márquez, E. Köhnen, E. Kasparavicius, S. Levcenco, L. Gil-Escrig, C. J. Hages, R. Schlatmann, B. Rech, T. Malinauskas, T. Unold, C. A. Kaufmann, L. Korte, G. Niaura, V. Getautis, S. Albrecht, Energy & Environmental Science 2019, 12, 3356.

[10] Q. Tan, Z. Li, G. Luo, X. Zhang, B. Che, G. Chen, H. Gao, D. He, G. Ma, J. Wang, J. Xiu, H. Yi, T. Chen, Z. He, Nature 2023.

[11] D. Meng, J. Xue, Y. Zhao, E. Zhang, R. Zheng, Y. Yang, Chemical Reviews 2022, 122, 14954.

[12] R. Azmi, S. Zhumagali, H. Bristow, S. Zhang, A. Yazmaciyan, A. R. Pininti, D. S. Utomo, A. S. Subbiah, S. De Wolf, Advanced Materials 2023, 2211317.

[13] M. A. Jameel, T. C.-J. Yang, G. J. Wilson, R. A. Evans, A. Gupta, S. J. Langford, Journal of Materials Chemistry A 2021, 9, 27170.

[14] A. A. Said, S. M. Wagalgave, J. Xie, A. L. Puyad, W. Chen, Z. Wang, S. V. Bhosale, S. V. Bhosale, Q. Zhang, Journal of Solid State Chemistry 2019, 270, 51.

[15] A. A. Said, J. Xie, Q. Zhang, Small 2019, 15, 1900854.

[16] S. Valero, A. Cabrera-Espinoza, S. Collavini, J. Pascual, N. Marinova, I. Kosta, J. L. Delgado, European Journal of Organic Chemistry 2020, 2020, 5329.

[17] S. Peng, J. Miao, I. Murtaza, L. Zhao, Z. Hu, M. Liu, T. Yang, Y. Liang, H. Meng, W. Huang, Journal of Materials Chemistry C 2017, 5, 5949.

[18] L. Li, Y. Wu, E. Li, C. Shen, H. Zhang, X. Xu, G. Wu, M. Cai, W.-H. Zhu, Chemical Communications 2019, 55, 13239.

[19] R. Azmi, E. Ugur, A. Seitkhan, F. Aljamaan, A. S. Subbiah, J. Liu, G. T. Harrison, M. I. Nugraha, M. K. Eswaran, M. Babics, Y. Chen, F. Xu, T. G. Allen, A. u. Rehman, C.-L. Wang, T. D. Anthopoulos, U. Schwingenschlögl, M. De Bastiani, E. Aydin, S. De Wolf, *Science* 2022, 376, 73.

[20] X. Deng, F. Qi, F. Li, S. Wu, F. R. Lin, Z. Zhang, Z. Guan, Z. Yang, C.-S. Lee, A. K.-Y. Jen, Angewandte Chemie International Edition 2022, 61, e202203088.

[21] R. Azmi, W. T. Hadmojo, S. Sinaga, C.-L. Lee, S. C. Yoon, I. H. Jung, S.-Y. Jang, Advanced Energy Materials 2018, 8, 1701683.

[22] C. Bi, Q. Wang, Y. Shao, Y. Yuan, Z. Xiao, J. Huang, Nature Communications 2015, 6, 7747.

[23] A. Farag et al., Adv. Energy Mater.2023, 13, 2203982.

## Claims

**1.** A compound of formula (I), (IV) or (V)

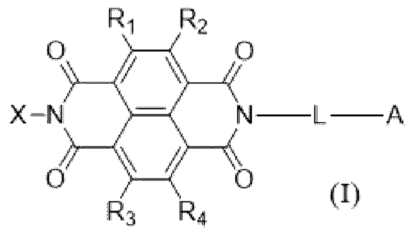

(I)

,

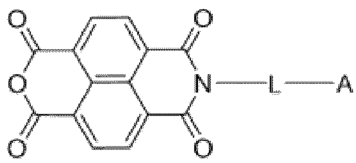

(IV),

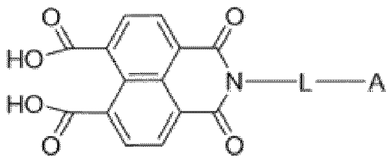

(V),

wherein

X is selected from $-L_1-A_1$, H, $NH_2$, $C_1-C_{10}$ alkyl, $C_2-C_{10}$ alkenyl, $C_2-C_{10}$ alkynyl, $C_4-C_{10}$ aryl, $C_4-C_{20}$ alkylaryl, $C_4-C_{20}$ alkenylaryl, and $C_4-C_{20}$ alkynylaryl, each of which is optionally substituted with $C_1-C_{10}$ alkyl, $C_2-C_{10}$ alkenyl, $C_2-C_{10}$ alkynyl, $C_1-C_{10}$ heteroalkyl, $C_4-C_{10}$ aryl, $C_2-C_{10}$ heteroalkenyl, $C_2-C_{10}$ heteroalkynyl, $C_4-C_{10}$ heteroaryl, or one or more heteroatoms selected from N, S and O;

$R_1$, $R_2$, $R_3$, $R_4$ is independently selected from H, CN, Cl, Br, F, $CF_3$, $NO_2$, $C_1-C_{20}$-alkyl, $C_{2-20}$-perfluoroalkyl, $C_{5-20}$-aryl, $C_{5-20}$-heteroaryl;

A, $A_1$, $A_2$ is independently selected from phosphonic acid, monoalkyl ether of phosphonic acid, phosphoric acid, monoalkyl ether of phosphoric acid:

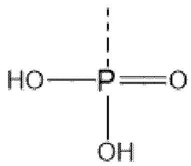

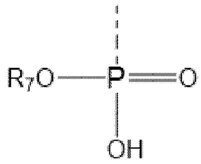

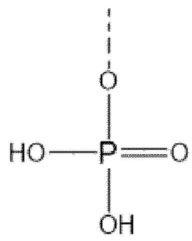

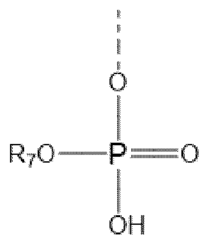

or a structure:

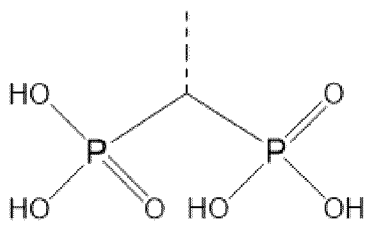

,

$R_7$ is $C_1-C_9$ alkyl group;

L, $L_1$ is independently selected from $C_1-C_9$ -alkylene, $C_4-C_{20}$ arylene, $C_4-C_{20}$ heteroarylene, $C_4-C_{20}$ alkylarylene, $C_4-C_{20}$ alkenarylene, $C_4-C_{20}$ heteroalkylarylene, $C_4-C_{20}$ heteroalkenarylene, wherein heteroatoms are selected from O, N, S, Se, Si, or from structure:

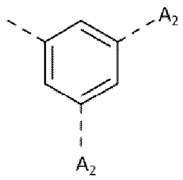

.

2. The compound according to claim 1, wherein (i) the compound is according to formula (I), and/or (ii) wherein when each of $R_1$, $R_2$, $R_3$, $R_4$ is H, and each of A, $A_1$ is phosphonic acid, then L, $L_1$ is independently selected from $C_3$-$C_9$ -alkylene, $C_4$-$C_{20}$ arylene, $C_4$-$C_{20}$ heteroarylene, $C_4$-$C_{20}$ alkylarylene, $C_4$-$C_{20}$ heteroalkylarylene, $C_4$-$C_{20}$ hetero-alkenarylene, wherein heteroatoms are selected from O, N, S, Se, Si, or from structure:

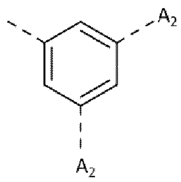

.

3. The compound according to any one of the preceding claims, wherein A, $A_1$, and $A_2$ is phosphonic acid.

4. The compound according to any one of the preceding claims, wherein L and $L_1$ are the same, and/or wherein X is $-L_1-A_1$.

5. The compound according to any one of claims 1 to 3, wherein X is selected from H, $NH_2$, $C_1$-$C_{10}$ alkyl, $C_2$-$C_{10}$ alkenyl, $C_2$-$C_{10}$ alkynyl, $C_4$-$C_{10}$ aryl, $C_4$-$C_{20}$ alkylaryl, $C_4$-$C_{20}$ alkenylaryl, and $C_4$-$C_{20}$ alkynylaryl, each of which is optionally substituted with $C_1$-$C_{10}$ alkyl, $C_2$-$C_{10}$ alkenyl, $C_2$-$C_{10}$ alkynyl, $C_1$-$C_{10}$ heteroalkyl, $C_4$-$C_{10}$ aryl, $C_2$-$C_{10}$ heteroalkenyl, $C_2$-$C_{10}$ heteroalkynyl, $C_4$-$C_{10}$ heteroaryl, or one or more heteroatoms selected from N, S and O; preferably, wherein X is selected from $C_4$-$C_{20}$ alkylaryl optionally substituted with $C_1$-$C_{10}$ alkyl.

6. A composition comprising one or more compounds according to any one of the preceding claims.

7. The composition according to claim 6, further comprising a filler molecule (FM), wherein FM is at least one kind of molecule consisting of an anchoring group, an alkyl chain of N carbon atoms, with N is in the range of 1 to 18, and a functional group of at least one of the group methyl, halogen, amino, bromide, ammonium and sulfuric functional group.

8. An optoelectronic and/or photoelectrochemical device comprising an electron transporting layer comprising the compound according to any one of claims 1 to 5 or the composition according to claim 6 or 7.

9. The optoelectronic and/or photoelectrochemical device according to claim 8, wherein the device is selected from a photovoltaic device, an organic photovoltaic device, a photovoltaic solid state device, an organic solar cell, a solid state solar cell, a perovskite solar cell, a tandem solar cell, a light emitting electrochemical cells, and OLED; preferably wherein the device is a photovoltaic device.

10. The photovoltaic device according to claim 9, comprising a conducting support layer covered with electron transporting layer, a sensitizer layer, a hole transporting layer, and a counter electrode, wherein the electron transporting layer comprises the compound according to any one of claim 1 to 5 or the composition according to claim 6 or 7; optionally, wherein the sensitizer layer comprises an organic-inorganic perovskite

11. The photovoltaic device according to claim 10, wherein the electron transporting layer consists of the compound according to any one of claims 1 to 5 or the composition according to claim 6 or 7.

12. The photovoltaic device according to any one of the claims 9 to 11, wherein the device is a tandem solar cell, preferably wherein the tandem solar cell comprises at least one perovskite solar cell.

13. The photovoltaic device according to any one of claims 10 to 12, wherein the sensitizer layer comprises an organic-inorganic perovskite, and wherein the organic-inorganic perovskite is a perovskite-type structure of formula (II):

$AMX_3$ (II)

wherein:

A is an alkali metal ion, preferably $Li^+$, $Na^+$, $K^+$, $Rb^+$, $Cs^+$; ammonium or amidinium ion, wherein one or more hydrogens are substituted by alkyl or acyl group;
M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;
X is monovalent anion, independently selected from the group consisting of $Cl^-$, $Br^-$, $I^-$, $NCS^-$, $CN^-$ , and $NCO^-$.

**14.** The photovoltaic device according to claim 13, wherein the organic-inorganic perovskite is a mixed perovskite-type structure according to formula (III):

$A^1_{1-y} A^2_y PbX^1_{3-z} X^2_z$ **(III)**

wherein:

$A^1$ and $A^2$ are organic monovalent cations independently chosen from Li+, Na+, K+, Rb+, Cs+, ammonium, or amidinium ion; wherein one or more hydrogens of said ammonium or amidinium ions are substituted by alkyl or acyl groups or halogens;
$X^1$ and $X^2$ are the same or different monovalent anions selected from Cl-, Br-, I-, NCS-, CN- and NCO-;
y is in the interval between 0.1 and 0.9; and
z is in the interval between 0.2 and 2.

**15.** The photovoltaic device according to any one of claims 10 to 14, wherein the conducting support layer comprises a conducting material selected from indium-doped tin oxide (ITO), indium zinc oxide (IZO), fluorine doped tin oxide (FTO), a metal, and/or other conductors.

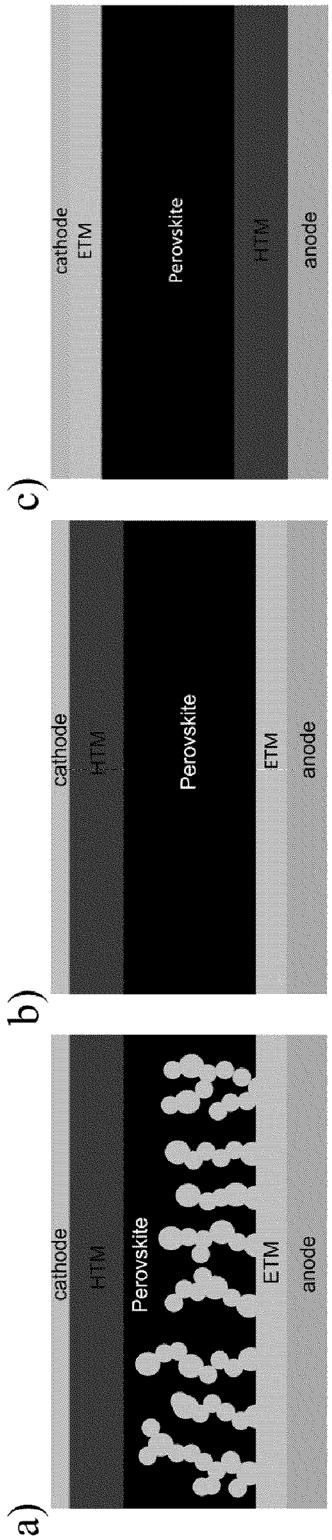
a)
cathode
HTM
Perovskite
ETM
anode
b)
cathode
HTM
Perovskite
ETM
anode
c)
cathode
ETM
Perovskite
HTM
anode

FIG. 1.

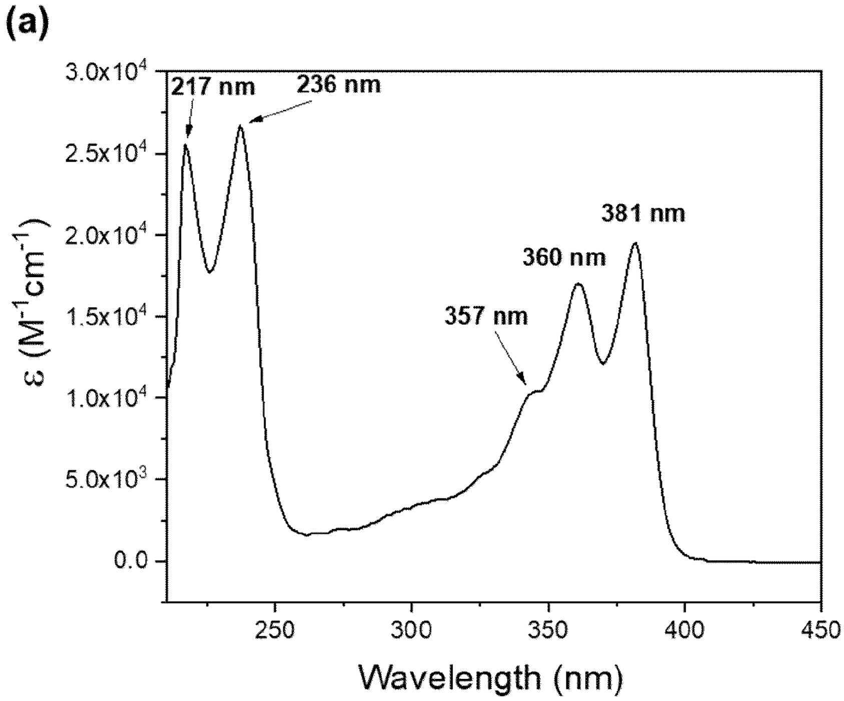
(a)
217 nm
236 nm
381 nm
360 nm
357 nm
ε (M-1cm-1)
Wavelength (nm)

FIG. 2a

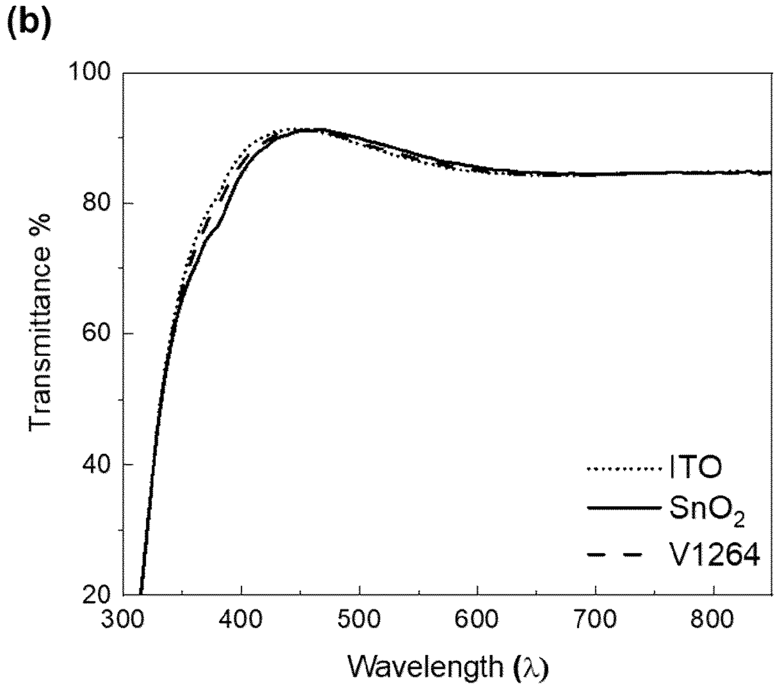
(b)
Transmittance %
ITO
SnO2
V1264
Wavelength (λ)

FIG. 2b

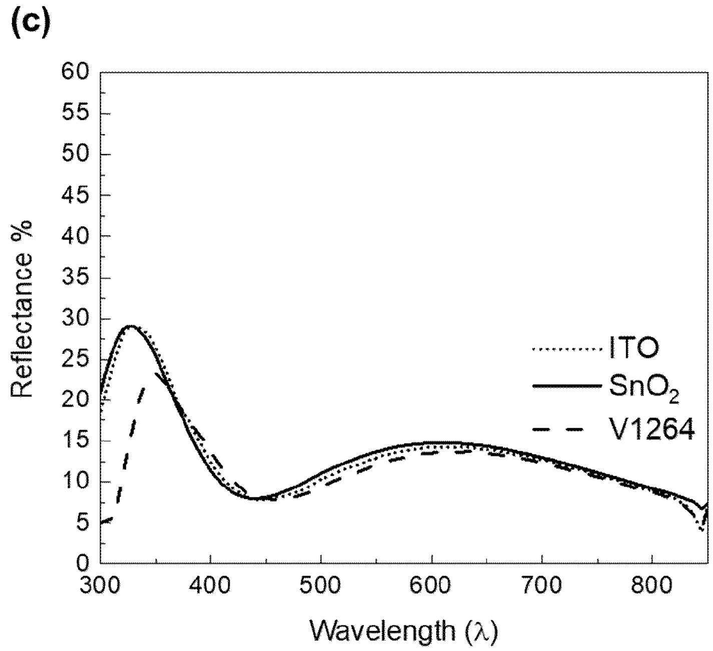
(c)
Reflectance %
Wavelength (λ)
ITO
SnO2
V1264
0
5
10
15
20
25
30
35
40
45
50
55
60
300
400
500
600
700
800

**FIG. 2c**

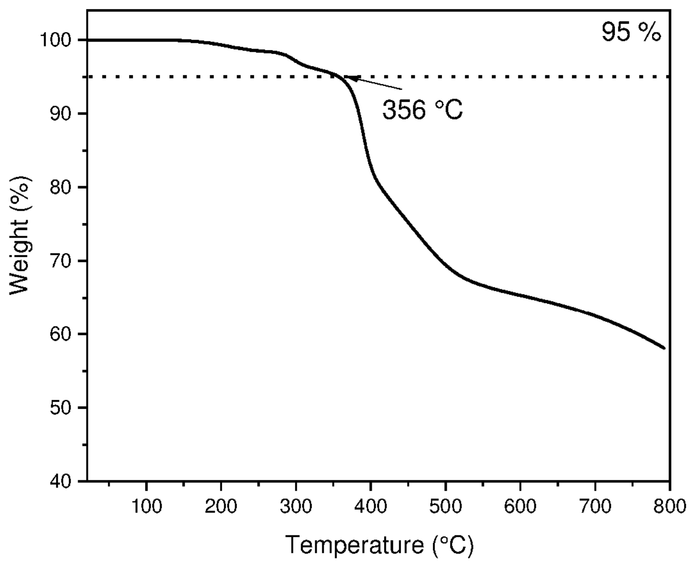
95 %
356 °C
Weight (%)
Temperature (°C)
40
50
60
70
80
90
100
100
200
300
400
500
600
700
800

**FIG 3.**

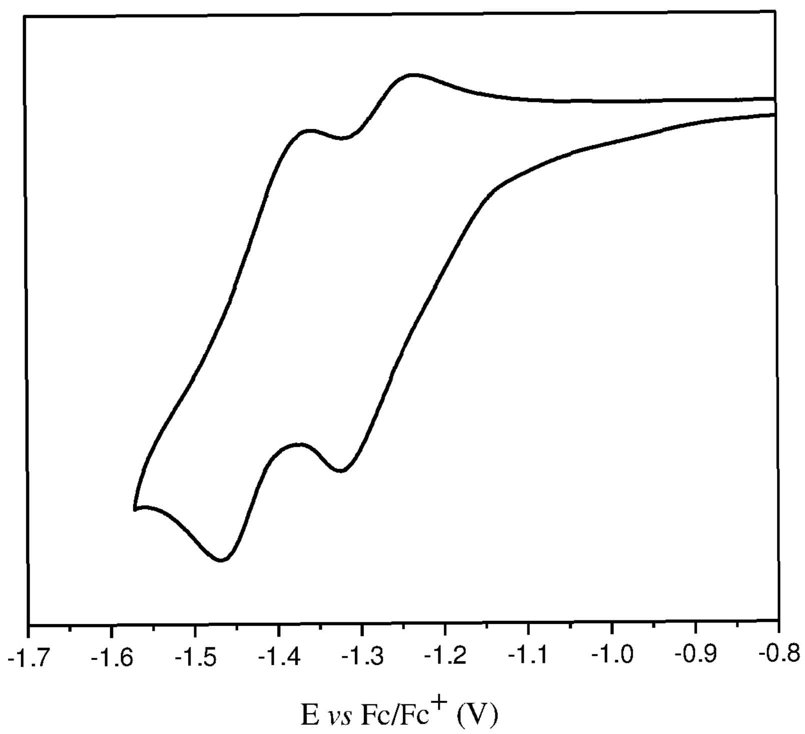


FIG. 4

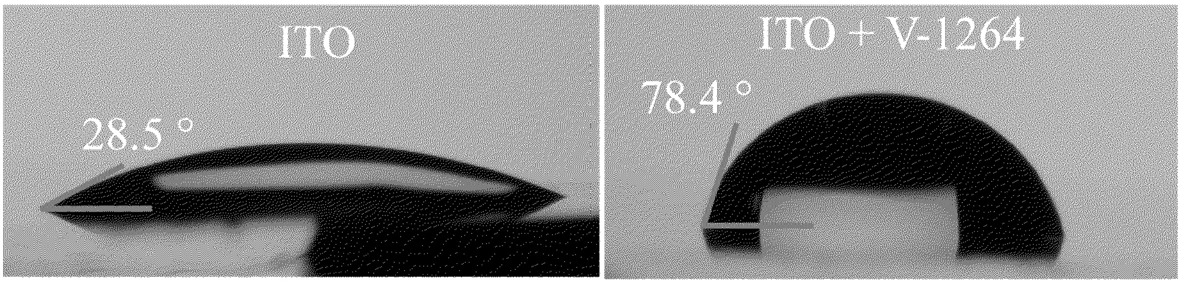


FIG. 5

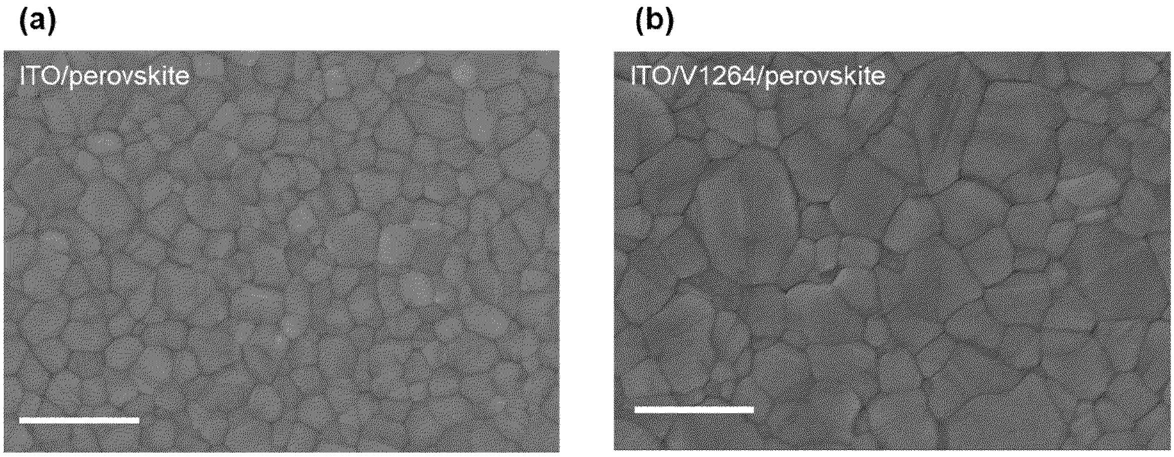


FIG. 6

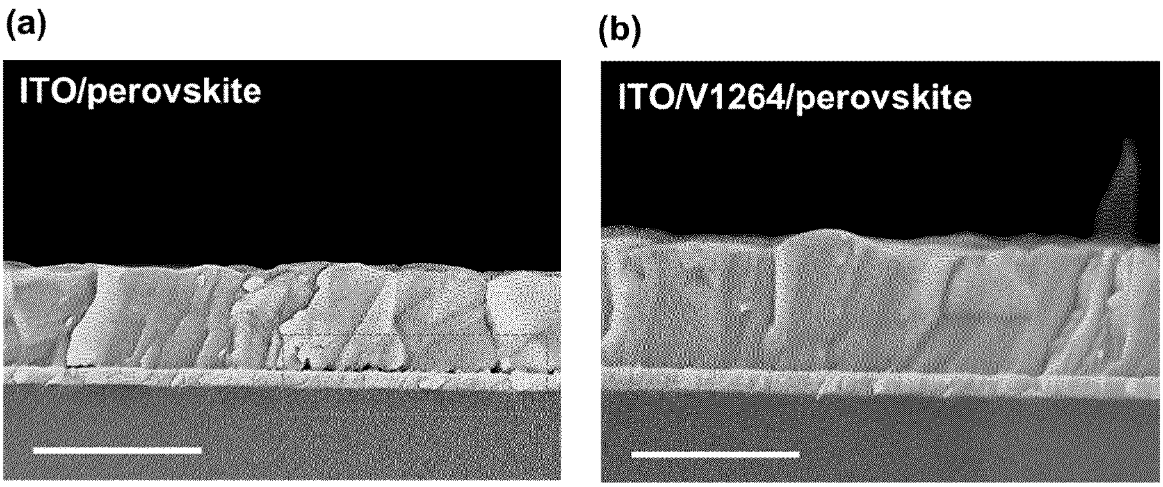


FIG. 7

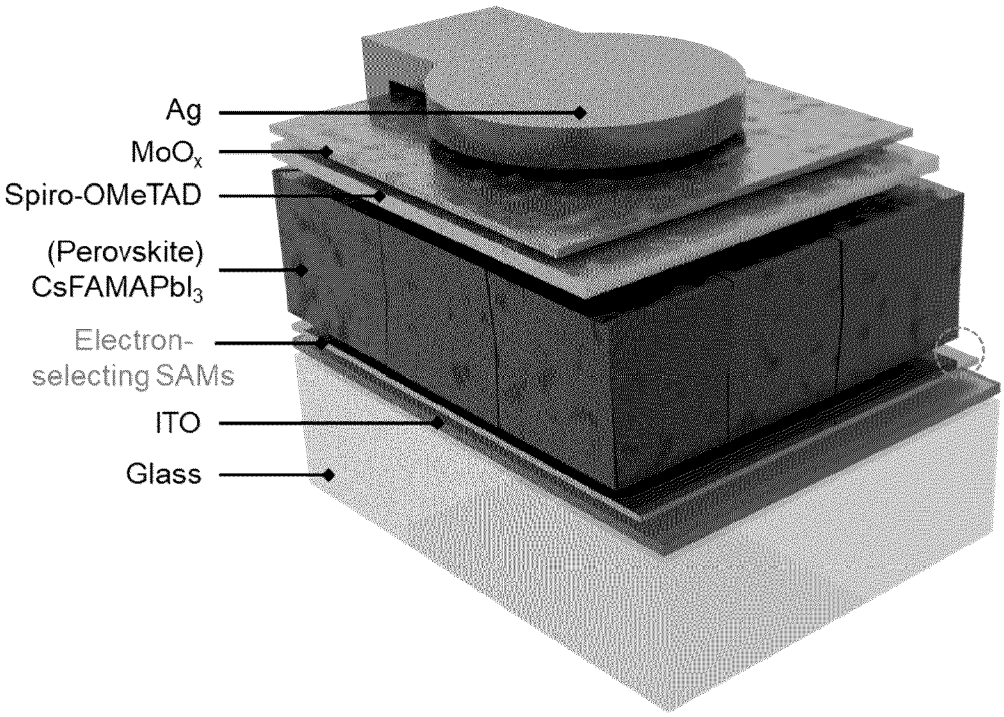
Ag
MoOx
Spiro-OMeTAD
(Perovskite)
CsFAMAPbI3
Electron-
selecting SAMs
ITO
Glass

FIG. 8

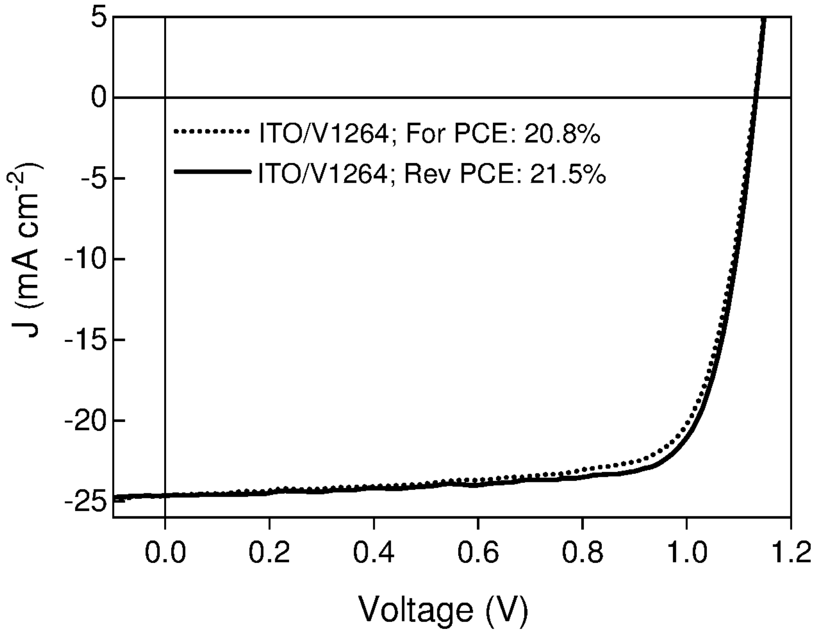

5
0
-5
-10
-15
-20
-25
J (mA cm$^{-2}$)
0.0
0.2
0.4
0.6
0.8
1.0
1.2
Voltage (V)
ITO/V1264; For PCE: 20.8%
ITO/V1264; Rev PCE: 21.5%


**FIG. 9**

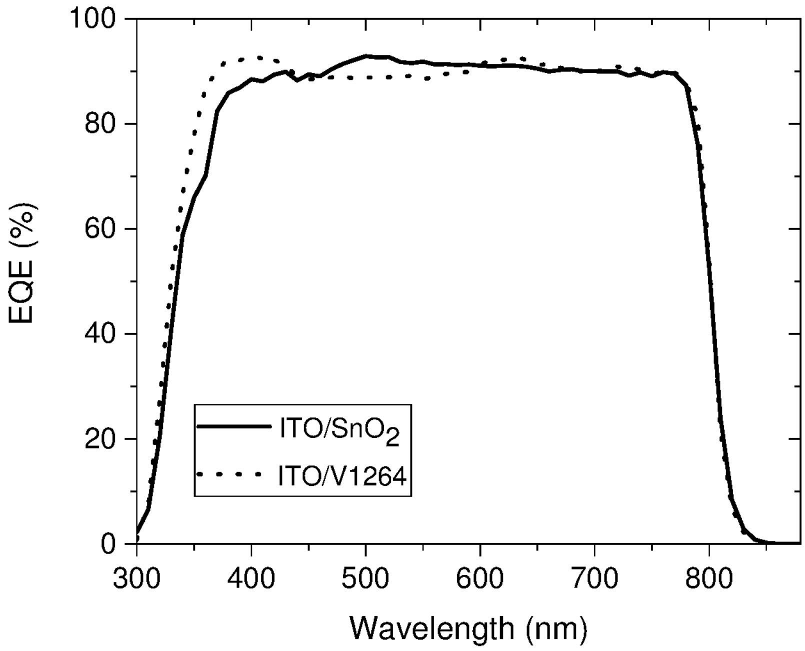

100
80
60
40
20
0
EQE (%)
300
400
500
600
700
800
Wavelength (nm)
ITO/$SnO_2$
ITO/V1264


**FIG. 10**

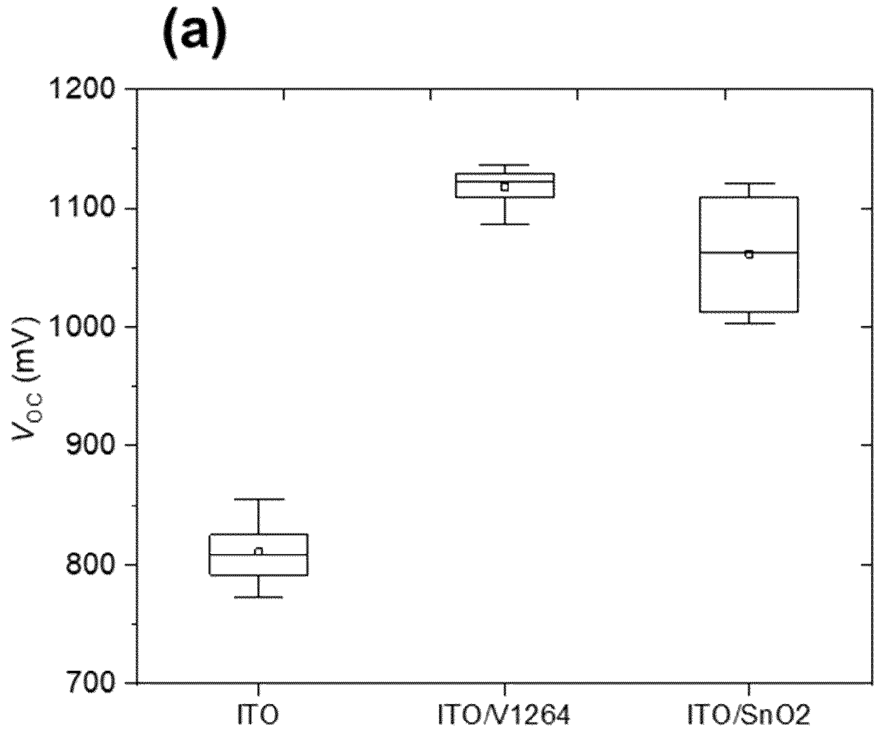


FIG. 11a

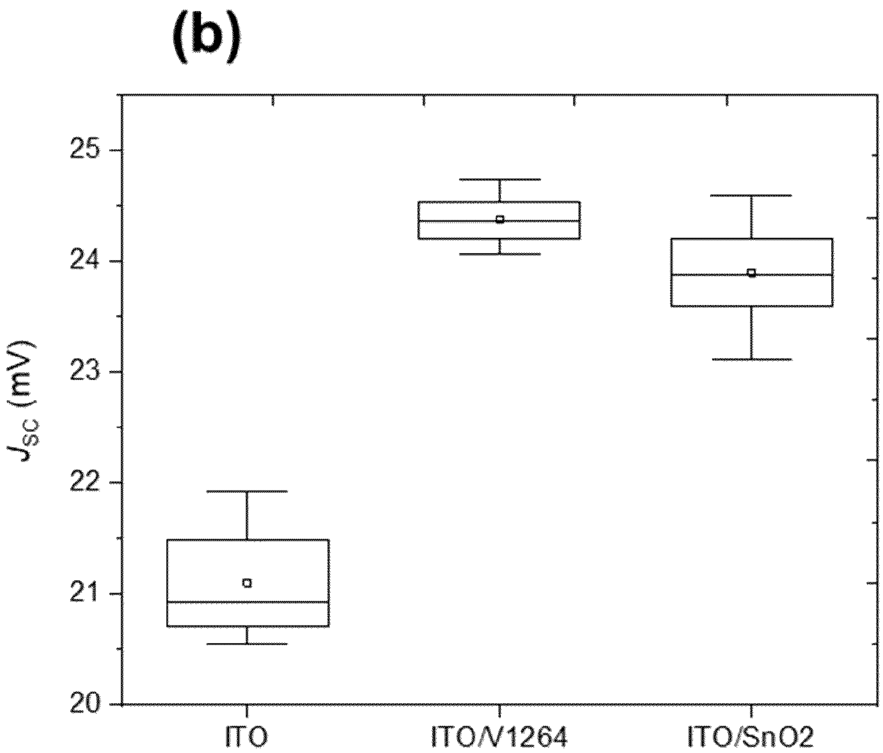


FIG. 11b

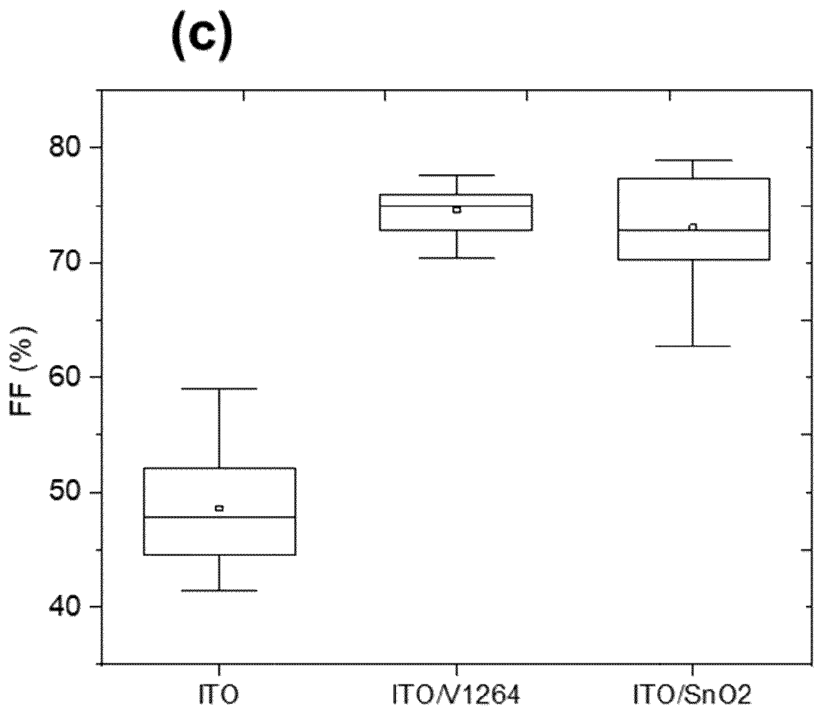


FIG. 11c

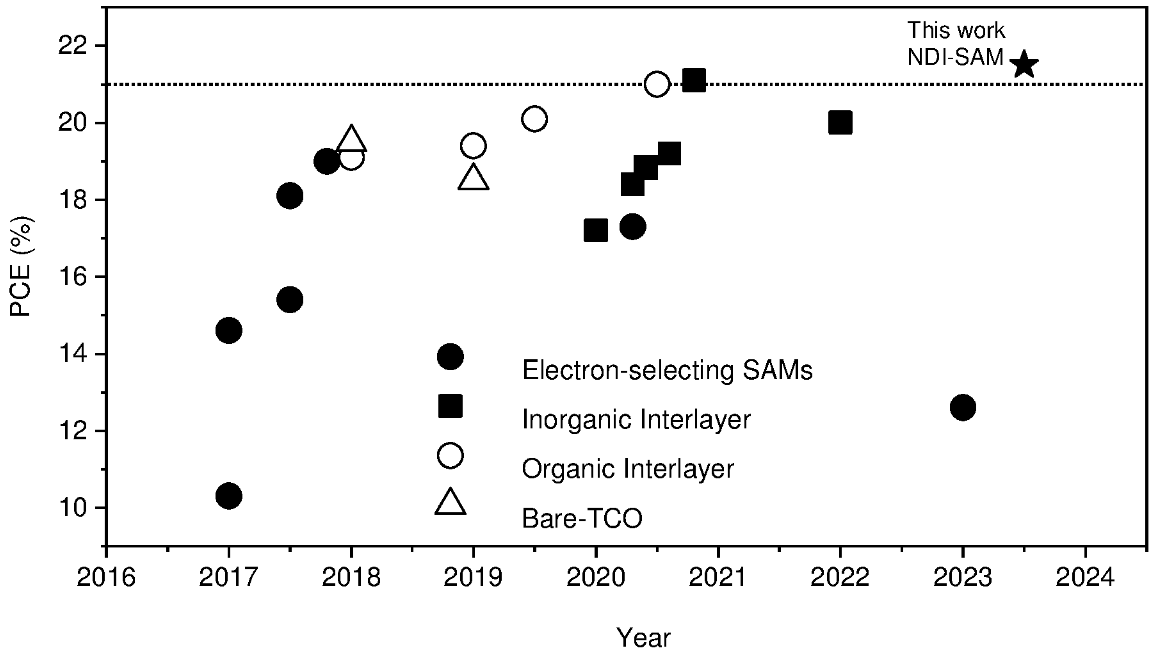


FIG. 12

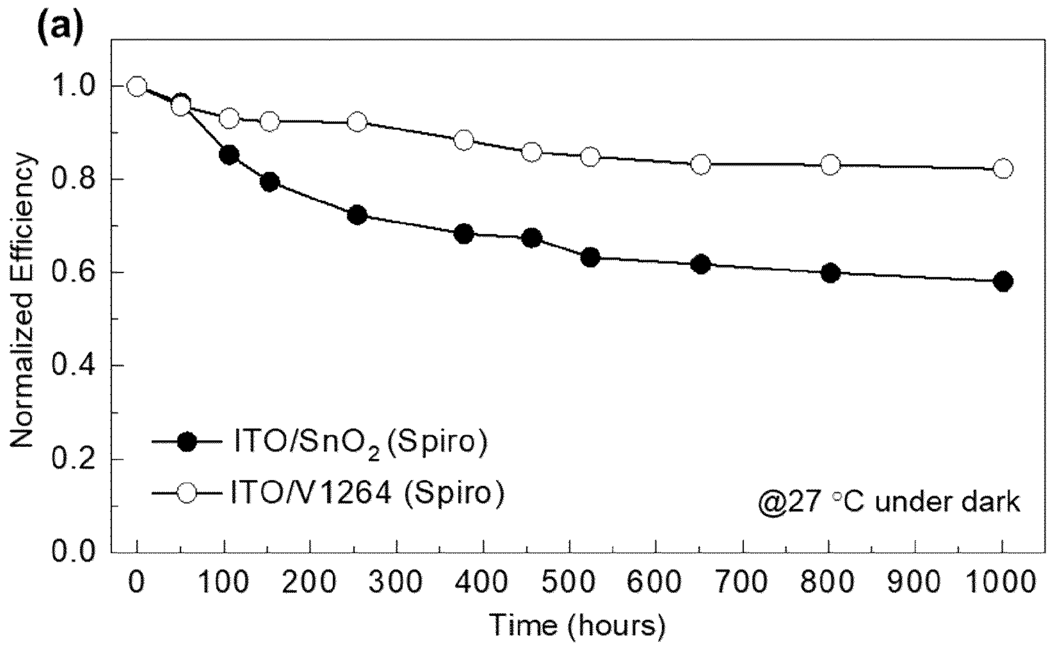


FIG. 13a

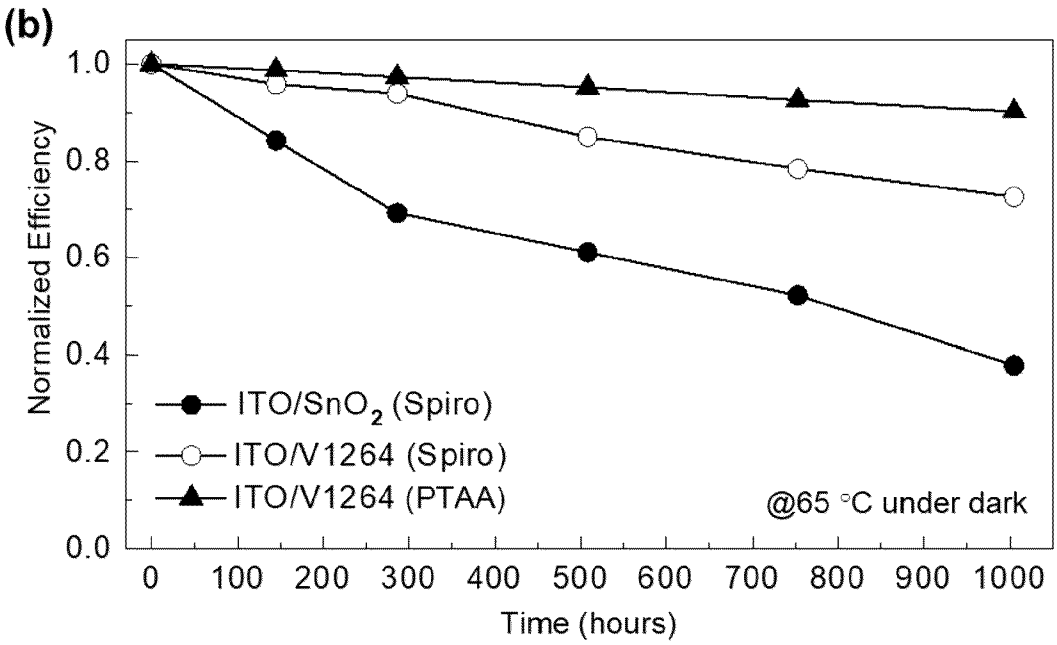


FIG. 13b

Europäisches Patentamt
European Patent Office
Office européen des brevets

# EUROPEAN SEARCH REPORT

Application Number
EP 25 15 2344

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 2023/097995 A1 (LONGI SOLAR TECH XIAN CO LTD [CN]) 8 June 2023 (2023-06-08)<br>* claims 1,5, 8 *<br>* compound PNDI *<br>* paragraphs [0006], [0035], [0058], [0061] *<br>* paragraphs [0063], [0066], [0071] *<br>* paragraphs [0111], [0166] *<br>* figure 1 *<br>----- | 1,2,4,5, 8-12,15<br>6,7,13, 14 | INV.<br>H10K30/50<br>H10K30/85 |
| X | BAYINDIR SINAN ET AL: "The electrical and photophysical performances of axially-substituted naphthalene diimide-based small molecules as interface layer",<br>MATERIALS SCIENCE AND ENGINEERING: B, vol. 294, 23 April 2023 (2023-04-23), page 116510, XP093273151, AMSTERDAM, NL<br>ISSN: 0921-5107, DOI: 10.1016/j.mseb.2023.116510<br>* scheme 1 compound 7 *<br>----- | 1 | TECHNICAL FIELDS SEARCHED (IPC)<br>H10K |
| Y | US 2018/122587 A1 (SATOU HIROTAKA [JP] ET AL) 3 May 2018 (2018-05-03)<br>* paragraph [0254] *<br>----- | 13,14 | |
| Y | DE 10 2019 116851 B3 (HELMHOLTZ ZENTRUM BERLIN FUER MAT UND ENERGIE GESELLSCHAFT MIT BESCHRA) 5 November 2020 (2020-11-05)<br>* paragraph [0016] *<br>----- | 6,7 | |

The present search report has been drawn up for all claims

2

| Place of search | Date of completion of the search | Examiner |
|---|---|---|
| Munich | 29 April 2025 | Pfattner, Raphael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 15 2344

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | Publication date | Patent family member(s) | Publication date |
|---|---|---|---|
| WO 2023097995 A1 | 08-06-2023 | CN 114335346 A | 12-04-2022 |
| | | WO 2023097995 A1 | 08-06-2023 |
| US 2018122587 A1 | 03-05-2018 | CN 107683536 A | 09-02-2018 |
| | | EP 3319137 A1 | 09-05-2018 |
| | | JP 6523455 B2 | 29-05-2019 |
| | | JP WO2017002644 A1 | 14-12-2017 |
| | | US 2018122587 A1 | 03-05-2018 |
| | | WO 2017002644 A1 | 05-01-2017 |
| DE 102019116851 B3 | 05-11-2020 | DE 102019116851 B3 | 05-11-2020 |
| | | EP 3987577 A1 | 27-04-2022 |
| | | WO 2020254665 A1 | 24-12-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **N. G. CONNELLY ; W. E. GEIGER**. *Chemical Reviews*, 1996, vol. 96, 877
- **V. V. PAVLISHCHUK ; A. W. ADDISON**. *Inorganica Chimica Acta*, 2000, vol. 298, 97
- **S.-K. JUNG ; J. H. HEO ; D. W. LEE ; S.-C. LEE ; S.-H. LEE ; W. YOON ; H. YUN ; S. H. IM ; J. H. KIM ; O.-P. KWON**. *Advanced Functional Materials*, 2018, vol. 28, 1800346
- **L. CHAO ; T. NIU ; W. GAO ; C. RAN ; L. SONG ; Y. CHEN ; W. HUANG**. *Adv. Mater.*, 2021, vol. 33, 2005410
- **F. FU ; J. LI ; T. C. YANG ; H. LIANG ; A. FAES ; Q. JEANGROS ; C. BALLIF ; Y. HOU**. *Adv. Mater.*, 2022, vol. 34, 2106540
- **J.Y. KIM ; J.W. LEE ; H.S. JUNG ; H. SHIN ; N.G. PARK**. *Chem Rev*, 2020, vol. 120, 7867-7918
- **H. MIN ; M. KIM ; S.-U. LEE ; H. KIM ; G. KIM ; K. CHOI ; J. H. LEE ; S. I. SEOK**. *Science*, 2019, vol. 366, 749
- **H. SI ; X. ZHAO ; Z. ZHANG ; Q. LIAO ; Y. ZHANG**. *Coordination Chemistry Reviews*, 2024, vol. 500, 215502
- **Y. YAO ; C. CHENG ; C. ZHANG ; H. HU ; K. WANG ; S. DE WOLF**. *Adv.Mater.*, 2022, vol. 34, 2203794
- **C. E. PUERTO GALVIS ; D. A. GONZALEZ RUIZ ; E. MARTINEZ-FERRERO ; E. PALOMARES**. *Chem. Sci.*, 2023
- **A. AL-ASHOURI ; A. MAGOMEDOV ; M. ROSS ; M. JOST ; M. TALAIKIS ; G. CHISTIAKOVA ; T. BERTRAM ; J. A. MÁRQUEZ ; E. KÖHNEN ; E. KASPARAVICIUS**. *Energy & Environmental Science*, 2019, vol. 12, 3356
- **Q. TAN ; Z. LI ; G. LUO ; X. ZHANG ; B. CHE ; G. CHEN ; H. GAO ; D. HE ; G. MA ; J. WANG**. *Nature*, 2023
- **D. MENG ; J. XUE ; Y. ZHAO ; E. ZHANG ; R. ZHENG ; Y. YANG**. *Chemical Reviews*, 2022, vol. 122, 14954
- **R. AZMI ; S. ZHUMAGALI ; H. BRISTOW ; S. ZHANG ; A. YAZMACIYAN ; A. R. PININTI ; D. S. UTOMO ; A. S. SUBBIAH ; S. DE WOLF**. *Advanced Materials*, 2023, 2211317
- **M. A. JAMEEL ; T. C.-J. YANG ; G. J. WILSON ; R. A. EVANS ; A. GUPTA ; S. J. LANGFORD**. *Journal of Materials Chemistry A*, 2021, vol. 9, 27170
- **A. A. SAID ; S. M. WAGALGAVE ; J. XIE ; A. L. PUYAD ; W. CHEN ; Z. WANG ; S. V. BHOSALE ; S. V. BHOSALE ; Q. ZHANG**. *Journal of Solid State Chemistry*, 2019, vol. 270, 51
- **A. A. SAID ; J. XIE ; Q. ZHANG**. *Small*, 2019, vol. 15, 1900854
- **S. VALERO ; A. CABRERA-ESPINOZA ; S. COLLAVINI ; J. PASCUAL ; N. MARINOVA ; I. KOSTA ; J. L. DELGADO**. *European Journal of Organic Chemistry*, 2020, vol. 2020, 5329
- **S. PENG ; J. MIAO ; I. MURTAZA ; L. ZHAO ; Z. HU ; M. LIU ; T. YANG ; Y. LIANG ; H. MENG ; W. HUANG**. *Journal of Materials Chemistry C*, 2017, vol. 5, 5949
- **L. LI ; Y. WU ; E. LI ; C. SHEN ; H. ZHANG ; X. XU ; G. WU ; M. CAI ; W.-H. ZHU**. *Chemical Communications*, 2019, vol. 55, 13239
- **X. DENG ; F. QI ; F. LI ; S. WU ; F. R. LIN ; Z. ZHANG ; Z. GUAN ; Z. YANG ; C.-S. LEE ; A. K.-Y. JEN**. *Angewandte Chemie International Edition*, 2022, vol. 61, e202203088
- **R. AZMI ; W. T. HADMOJO ; S. SINAGA ; C.-L. LEE ; S. C. YOON ; I. H. JUNG ; S.-Y. JANG**. *Advanced Energy Materials*, 2018, vol. 8, 1701683
- **C. BI ; Q. WANG ; Y. SHAO ; Y. YUAN ; Z. XIAO ; J. HUANG**. *Nature Communications*, 2015, vol. 6, 7747
- **A. FARAG et al.** *Adv. Energy Mater.*, 2023, vol. 13, 2203982